# EUROPEAN PATENT SPECIFICATION

(11) **EP 3 502 728 B1**
(45) Date of publication and mention of the grant of the patent: **12.05.2021**
(21) Application number: 17209961.6
(22) Date of filing: 22.12.2017
(51) Int. Cl.: G01R 33/56, G01N 24/08

(54) **METHOD AND SYSTEM TO DETECT A SOLUTE IN A SOLVENT USING NUCLEAR MAGNETIC RESONANCE**
VERFAHREN UND SYSTEM ZUR ERKENNUNG EINES GELÖSTEN STOFFS IN EINEM LÖSUNGSMITTEL MITTELS MAGNETISCHER KERNRESONANZ
PROCÉDÉ ET SYSTÈME POUR DÉTECTER UN SOLUTÉ DANS UN SOLVANT UTILISANT LA RÉSONANCE MAGNÉTIQUE NUCLÉAIRE

(43) Date of publication of application: 26.06.2019
(73) Proprietor: Julius-Maximilians-Universität Würzburg, 97070 Würzburg (DE)
(72) Inventor: Gutjahr, Fabian Tobias, 97084 Würzburg (DE); Munz, Eberhard, 97074 Würzburg (DE); Jakob, Peter, 97262 Hausen (DE)
(74) Representative: Lucke, Andreas

(56) References cited:
- WO-A1-2011/059543
- PETER C. M. VAN ZIJL ET AL: "Chemical exchange saturation transfer (CEST): What is in a name and what isn't?", MAGNETIC RESONANCE IN MEDICINE., vol. 65, no. 4, 1 April 2011 (2011-04-01), pages 927-948, XP055479053, US ISSN: 0740-3194, DOI: 10.1002/mrm.22761
- RAY K. ET AL.: "Separation of intracellular and extracellular Z-spectra by DiffusionCEST", PROCEEDINGS OF THE INTERNATIONAL SOCIETY FOR MAGNETIC RESONANCE IN MEDICINE, 24TH ANNUAL MEETING & EXHIBITION, no. 302, 22 April 2016 (2016-04-22), XP040681345, Singapore

## Description

### FIELD OF THE INVENTION

The present invention is in the field of nuclear magnetic resonance imaging. More precisely, the invention relates to a nuclear magnetic resonance technique exploiting the chemical exchange of nuclear spins between molecules.

### BACKGROUND

Nuclear magnetic resonance provides a noninvasive method to study organic matter and has found wide applications in imaging systems for biomedical diagnosis. Traditionally, nuclear magnetic resonance provides a two- or three-dimensional map that correlates to the spin-density and spin relaxation times of protons, which can allow drawing conclusions on the tissue composition in the investigated area.

To measure the nuclear spins of the protons, the investigated sample is placed in a strong longitudinal magnetic field, which aligns a surplus of nuclear spins with the magnetic field direction. Then, radiofrequency pulses can be applied to the sample at a resonance frequency specific to the proton to modulate the spin orientation of the nuclear spins and introduce a finite transverse spin component. The transverse spin components will then precess around the direction of the applied longitudinal field with a characteristic frequency, an effect called Larmor precession, which leads to a periodically varying transverse magnetization in the sample. This periodically varying magnetization change generates a characteristic radiofrequency signal that can be measured to analyze the sample.

Since the proton resonance frequency changes depending on its molecular environment, it is also possible to selectively excite and measure the protons in specific molecular compounds. This can allow directly detecting the concentration of specific molecules or organic contrast agents that have low toxicity to the human body. However, the signal obtained by directly imaging specific molecular compounds is usually low due to the limited concentration of the molecule in the sample.

The signal can be increased with a technique called Chemical Exchange Saturation Transfer as described in van Zijl et al. (Magnetic Resonance in Medicine 65:927-948; 2011). In this technique, a constant low-power radiofrequency pulse or a train of selective radiofrequency pulses saturates the nuclear spins of protons in a tracer molecule and thereby randomizes the spin orientation, which leads to a zero net magnetization of the nuclear spins. The tracer molecule is chosen such that one of its protons is chemically exchanged to a water molecule when in solution. Due to this chemical exchange of the proton, the nuclear spin saturation can be transferred to surrounding water molecules. If this transfer is sufficiently fast, the tracer molecule can be continuously (or repeatedly) saturated and the saturation signal can be spread to the surrounding water molecules, which opens the possibility to greatly increase the signal strength generated from the tracer molecule.

The signal obtained by the chemical exchange saturation transfer technique is a reduction of the initial nuclear magnetic resonance signal due to the saturation transfer from the tracer molecule. It is therefore necessary to obtain at least one reference measurement of the initial state to correctly attribute the signal contribution of the tracer molecule.

WO 2011/059543 A1 discloses a magnetic resonance imaging and spectroscopy method and corresponding device for generating CEST signals of a solute in a solvent by selectively exciting protons of the solute with π/2 excitations. Using two subsequent frequency-selective RF pulses followed by a dephasing pulse, frequency labeling of excited protons can be performed according to the separation of the two pulses.

### SUMMARY OF THE INVENTION

The problem is therefore to provide a positive nuclear magnetic resonance signal originating from a solute in a solvent with improved background signal suppression.

The invention relates to a method and a system for detecting a solute in a solvent using nuclear magnetic resonance according to the independent claims. The dependent claims relate to preferred embodiments.

In a first aspect, the invention relates to a method for detecting a solute in a solvent using nuclear magnetic resonance, said method comprising a step of encoding an excitation in a nuclear spin of the solute comprising at least one preparation sequence, wherein said preparation sequence comprises the steps of: applying a first radiofrequency pulse to the nuclear spin at a resonance frequency of the solute; and applying a first magnetic field gradient pulse suitable for changing a phase of the nuclear spin. The method further comprises a step of measuring the excitation in the nuclear spin, said measuring including the steps of: applying a refocusing radiofrequency pulse at a resonance frequency of the solvent for refocusing said nuclear spin transferred to the solvent by chemical exchange; applying a second magnetic field gradient pulse to thereby select the excitation in the nuclear spin; and performing a measurement of the excitation in the nuclear spin excited by the first radiofrequency pulse at the resonance frequency of the solute and refocused with the refocusing radiofrequency pulse at the resonance frequency of the solvent.

Note that herein, and in the appended claims, reference is made to "a spin" and "the spin" (singular) for a clear definition of the processes carried out with regard to the spin. The skilled person will nevertheless appreciate that in NMR applications the processes will usually take place for a plurality of spins in parallel. Accordingly, when reference to "a spin" is made, this is to be understood as referring to "at least one of', or "an exemplary one of' a plurality of spins.

The method addresses the above mentioned problem by providing a way to generate a direct signal originating from an induced excitation in the nuclear spin, while spurious excitations of other nuclear spins can be suppressed.

To initialize the protons of the solvent and the solute, the nuclear spins should initially be aligned in a longitudinal magnetic field. Therefore, in preferred embodiments, the method further comprises a step of applying a longitudinal magnetic field for aligning the nuclear spin of the solute along a longitudinal direction. During the method, the magnetic field is continuously applied to define a Larmor frequency for the nuclear spins.

The solute may be a molecule dissolved in the solvent and should perform chemical exchange of protons with the solvent at a certain exchange rate. The resonance frequencies of the proton in the solute or in the solvent should differ by a chemical shift, which may be characteristic for the solute. In particular, the solute is chosen, such that the chemical shift of the solute with respect to the solvent is equal or higher than the exchange rate. In this way, the solute can be selectively excited by the radiofrequency pulse.

The encoding of the excitation by the preparation sequence can modify the longitudinal spin component of the nuclear spin of the solute and/or its phase predictably. This excitation can then be transferred via chemical exchange to the solvent. Preferably, nuclear spins of the solvent are not directly excited by the preparation sequence or the excitation of the solvent by the preparation sequence is minimized.

The first radiofrequency pulse at the resonance frequency of the solute generates an oscillating transverse magnetic field component, which may change the spin orientation of the nuclear spin of the solute. The pulse amplitude and/or pulse length should be chosen such that the spin orientation after the first radio frequency pulse comprises a finite transverse component.

The transverse spin component can precess around an externally applied field with the Larmor frequency, which is related to an external longitudinal magnetic field strength. Hence, a spin orientation of the nuclear spin may become dependent on time as well as the magnetic field strength.

The magnetic field gradient pulse changes the spatial dependence of the magnetic field strength across the solvent according to a gradient distribution having a gradient amplitude. Conventionally, magnetic field gradient pulses induce a substantially linear variation of the magnetic field strength across the investigated sample. In principle, for encoding the excitation, any deterministic magnetic field gradient distribution may be used. However, for the sake of brevity, the invention will in the following be described with the commonly used linear magnetic field gradients. The gradient amplitude then corresponds to a difference between the minimum and maximum value of the magnetic field induced by the magnetic field gradient pulse in the investigated sample area. The magnetic field gradient pulse is applied during a pulse duration. The product of the gradient amplitude and pulse duration will be referred to as gradient pulse area.

Different magnetic field gradient pulses, whose amplitude or gradient pulse area is compared, are considered to have substantially the same gradient orientation, i.e. the direction along which the magnetic field strength varies is considered to be substantially the same and the maximum and minimum absolute values of the magnetic field strength are located in substantially identical locations. Additionally, the skilled person will appreciate that the magnetic field gradient pulses may be composite magnetic field gradient pulses, such as a magnetic field gradient pulse composed of a plurality of magnetic field gradient portions, wherein the magnetic field gradient portions may be spaced by periods during which no magnetic field gradient portion is applied to the sample, and wherein the magnitude and/or sign of different magnetic field gradient portions may be different. When the gradient pulse areas of composite magnetic field gradient pulses are compared, the sum of the gradient pulse areas of the respective magnetic field gradient portions is considered.

If the magnetic field gradient pulse is applied after the first radiofrequency pulse, the magnetic field gradient pulse may imprint a location dependent relative orientation change of the transverse spin component of the nuclear spin (i.e. a location dependent phase change), which depends on the gradient pulse area.

Preferably, the gradient pulse area is chosen such that the nuclear spins of the solvent and/or the solute are fully dephased and no signal may be measured across the solvent and/or the solute after the magnetic field gradient pulse. The first magnetic field gradient pulse may allow suppressing a spurious excitation of the solvent or other solutes, while encoding a location dependent phase change of the nuclear spin of the solute.

In some embodiments, the preparation sequence comprises a finite exchange period after applying the first magnetic field gradient pulse. The finite exchange period could e.g. have a duration related to the inverse of the exchange rate of the solute, i.e. the exchange time. Thus, the excitation may be transferred from the solute to the solvent by chemical exchange during the preparation sequence. An exchange period shorter than the exchange time may counteract a T1-relaxation of the excitation from a previous preparation sequence during the exchange period, while an exchange period longer than the exchange time may increase an amount of excitations transferred from the solute to the solvent during the preparation sequence.

Typically, the concentration of the solute in the solvent is low, such that each molecule of the solute may chemically exchange its nuclear spin with a plurality of molecules of the solvent. The nuclear spin of the solvent chemically exchanged to the solute in return may be aligned with the longitudinal magnetic field direction. Thus, after each preparation sequence, the refreshed nuclear spins of the solute are aligned with the longitudinal magnetic field direction.

The preparation sequence may then be repeated to repeatedly encode an excitation in the nuclear spins of the solute which may be transferred to the solvent for a plurality of preparation sequences.

During the preparation sequences, the nuclear spins may accumulate an additional random phase change, which can dephase the excited nuclear spins. The additional random phase change may for example originate from inhomogeneities in the longitudinal magnetic field.

However, the encoded excitation chemically transferred to the solvent from the solute may be recovered using the refocusing radiofrequency pulse. The refocusing radiofrequency pulse may generate an oscillating transverse magnetic field component, which may change the spin orientation of the nuclear spin of the solvent. The pulse amplitude and/or pulse length should be chosen such that the spin orientation after the first radio frequency pulse comprises a finite transverse component. Further, the pulse amplitude and/or pulse length should be chosen such that, after the refocusing radiofrequency pulse, the nuclear spin is refocused by partially reversing the previous evolution of the nuclear spins, which may be analogous to a spin echo refocusing pulse, such as a Hahn echo refocusing pulse.

The second magnetic field gradient pulse may allow selecting the excitation encoded in the solute by the preparation sequence, which has been transferred to the solvent. The second magnetic field gradient pulse may have a gradient pulse area chosen such that any excitation of nuclear spins, which have not been encoded with an excitation by the preparation sequence, is dephased, and hence does not contribute to the measured signal.

According to the invention, the second magnetic field gradient pulse and the first magnetic field gradient pulse have the same gradient pulse area or a gradient pulse area deviating by 5% or less, preferably 1% or less, such as having the same gradient pulse area within the limitations of a gradient producing system.

In this way, the second magnetic field gradient pulse in combination with the refocusing radiofrequency pulse may reverse the effect of the first magnetic field gradient pulse and may thereby select the encoded excitation encoded by the preparation sequence, while other excited nuclear spins may be dephased. A dephased ensemble of nuclear spins does not contribute a signal to a following nuclear magnetic resonance measurement.

In some embodiments, the method further comprises the step of measuring a magnetic resonance signal at a resonance frequency of the nuclear spin of the solvent and after applying the second magnetic field gradient pulse.

The magnetic resonance signal may originate from an oscillating transverse magnetic field component generated by the nuclear spins of the solvent following the refocusing radiofrequency pulse and the second magnetic field gradient pulse.

In preferred embodiments, the first radiofrequency pulse is a π/2-pulse or deviating from a π/2-pulse by π/4 or less, in particular π/6 or less, preferably π/9 or less.

A π/2-pulse is a pulse with a flip angle of π/2, i.e. a pulse which leads to a π/2 rotation of the spin orientation of the nuclear spin around a transverse axis. A measured magnetic resonance signal following a π/2-pulse may have a maximum strength, while a pulse deviating from a π/2-pulse may have a lower pulse amplitude or pulse duration. The lower pulse amplitude may have a reduced adverse effect on organic matter, while the lower pulse duration may allow reducing the duration of the preparation sequence. In this context, a first radiofrequency pulse with a low flip angle may also be used to generate a stimulated echo, such as a π/6-pulse. Furthermore, the first radiofrequency pulse may deviate from a π/2-pulse due to imperfections.

In preferred embodiments, the refocusing radiofrequency pulse is a π-pulse or deviating from a π-pulse by π/9 or less, preferably π/18 or less.

When the refocusing radiofrequency pulse is a π-pulse, the spin orientation of the nuclear spin may be inversed by the refocusing radiofrequency pulse. Hence, an evolution of the spin orientation may be effectively reversed following the refocusing radiofrequency pulse. Thus, a spin echo may be induced at a time after the refocusing radiofrequency pulse corresponding to a delay between the first radiofrequency pulse and the refocusing radiofrequency pulse.

In preferred embodiments, a number of preparation sequences is used to encode the excitation, and an equal number of second gradient pulses is used to select the excitation in the nuclear spin, in particular wherein the number is greater than 1, preferably greater than 10, most preferably greater than 20, such as 80 or 100.

When the refocusing radiofrequency pulse is a π-pulse, the spin echo originating from a preparation sequence may appear with a delay from the refocusing radiofrequency pulse that is equal to the delay between the preparation sequence and the refocusing radiofrequency pulse.

The nuclear spin excited by a certain preparation sequence may evolve according to any first magnetic field gradient pulse applied during the following preparation sequences. Hence, to select the nuclear spin excited by the first preparation sequence, an equal number of second magnetic field gradient pulses may be used to reverse the effect of the number of first magnetic field gradient pulses. The same applies for the other preparation sequences.

Therefore, the refocusing radiofrequency pulse in combination with the plurality of second magnetic field gradient pulses may give rise to a plurality of nuclear magnetic resonance signals, whose point in time is known and whose signals can be summed to detect the solute in the solvent.

In preferred embodiments, the preparation sequence further comprises the step of: applying a second radiofrequency pulse at the resonance frequency of the solute after applying the first magnetic field gradient pulse.

Preferably, the second radiofrequency pulse is applied before an expected time of exchange of the nuclear spin of the solute with the solvent has passed. Hence, the excitation encoded by the first radiofrequency pulse and the first magnetic field gradient pulse may be modified with the second radiofrequency pulse prior to the exchange. For example, the first radiofrequency pulse may induce a finite transverse spin component onto the nuclear spin, while the second radiofrequency pulse may at least partially transform the transverse spin component of the nuclear spin into a longitudinal spin component. The longitudinal spin component may be preserved during a longer time and may reduce an effect of additional preparation sequences onto the nuclear spin.

In preferred embodiments, the first and the second radiofrequency pulses produce the same flip angle or a flip angle deviating by 30% or less, preferably 10% or less, most preferably 5% or less, in particular wherein the first and the second radiofrequency pulses are π/2-pulses or deviating from a π/2-pulse by π/4 or less, preferably π/6 or less, most preferably π/9 or less.

If the first and the second radiofrequency pulses produce substantially the same flip angle, the transverse component induced by the first radiofrequency pulse may be transferred back to the longitudinal direction by the second radiofrequency pulse. Hence, the excitation encoded by the preparation sequence may be less affected by following preparation sequences. A larger portion of the encoded excitation may be transferred to the longitudinal direction, if the deviation from a π/2-pulse of the first and second radiofrequency pulses is lower. However, any flip angles may be used for the first and second radiofrequency pulses, although deviating from a condition of the first and second radiofrequency pulses having the same flip angle may reduce the portion of spins refocused by the refocusing pulse and thereby the measured signal.

In some embodiments, the refocusing radiofrequency pulse applied to the solvent resonance corresponds to a π/2-pulse or deviates from a π/2-pulse in a similar manner as the first and second radiofrequency pulses. The combination of the first, second and refocusing radiofrequency pulses may give rise to a stimulated echo of the nuclear spin. In particular, the stimulated echo can induce a magnetic resonance signal with a delay given by the temporal spacing (i.e. the separation time) between the first and the second radiofrequency pulses after the time of the refocusing radiofrequency pulse.

As the temporal spacing between the first and the second radiofrequency pulses may be equal between preparation sequences, a stimulated echo of the excitation encoded by a plurality of preparation sequences may appear at the same time after the refocusing radiofrequency pulse. Hence, at a predetermined point in time, the stimulated echo of a plurality of preparation sequences may constructively overlap to generate a nuclear magnetic resonance signal.

The strength of the stimulated echo may increase with the number of preparation sequences performed before the refocusing radiofrequency pulse. The increase of the strength of the stimulated echo may be limited by Ti-relaxation of the nuclear spins in the solvent and/or the solute. As the first magnetic field gradient pulse may be equal between preparation sequences, the second magnetic field gradient pulse may select all of the nuclear spins with an excitation encoded by any of the preparation sequences, while spurious excitations of the solvent or further solutes may be dephased by the second magnetic field gradient pulse.

Additionally, the excited spins will be refocused with a specific phase, which is encoded by the phase difference between the first and second radiofrequency pulses. Hence, the phase information acquired by the measurement may be used to infer the spatial distribution of the solute in the measurement area. The magnitude and phase information of the measured signal may then be combined for improving the detection of the solute in the measurement area. Moreover, the measurement may be repeated with a different phase difference between the first and second radiofrequency pulses to improve the identification of the signal originating from the solute.

In some embodiments, the single refocusing radiofrequency pulse can be replaced by a sequence of low flip angle pulses to generate a series of stimulated echoes, e.g. for probing several lines of the k-space of the nuclear spins. Further, the stimulated echo may be recovered multiple times using spin echo techniques, for example by applying a radiofrequency pulse with a flip angle of π after the stimulated echo, and the signal originating from the solute may be measured after the first stimulated echo, or may be measured multiple times after the refocusing radiofrequency pulse.

In preferred embodiments, the method further permits detecting a second solute, wherein the preparation sequence further includes the steps of: applying a third radiofrequency pulse to a second nuclear spin at a resonance frequency of the second solute; and applying a third magnetic field gradient pulse suitable for changing a phase of the second nuclear spin; applying a fourth radiofrequency pulse to the second nuclear spin at a resonance frequency of the second solute; wherein a phase of the fourth radiofrequency pulse is different from a phase of the third radiofrequency pulse; and wherein the gradient pulse area of the first, second and third magnetic field gradient pulses are in particular equal or deviating by 5% or less, preferably 1% or less, such as having the same gradient pulse area within the limitations of a gradient producing system. Preferably, the measurement is configured to distinguish a first signal corresponding to the (first) solute and a second signal corresponding to the second solute according to the phases of the measured signals, the phases of the measured signals being encoded by the phase difference between the first and second radiofrequency pulses and the phase difference between the third and fourth radiofrequency pulses.

The third and fourth radiofrequency pulses may be chosen similar to the first and second radiofrequency pulses. The phase difference of the fourth radiofrequency pulse with respect to the third radiofrequency pulse may be different from a phase difference of the first radiofrequency pulse with respect to the second radiofrequency pulse. Hence, the solute and the second solute may be distinguished in the nuclear magnetic resonance signal by a phase difference of the signals.

In some embodiments, the phase difference between the third and the fourth radiofrequency pulse may be equal to π, or deviating from π by π/2 or less, preferably by π/3 or less, although any phase may be used which can be distinguished by the measurement.

In some embodiments, the third radiofrequency pulse may be applied before the first magnetic field gradient pulse and the fourth radiofrequency pulse may be applied after the first magnetic field gradient pulse. Thus, the third magnetic field gradient pulse may be the first magnetic field gradient pulse. In this case, the duration of the preparation sequence for detecting two different solutes may be reduced.

The second solute is chosen such that a resonance frequency of the second solute is different from a resonance frequency of the (first) solute. Preferably, a difference between the resonance frequency of the first solute and the second solute is larger than a width of the respective resonances. Most preferably, a chemical shift +Δω of the first solute has opposite sign to a chemical shift of the second solute with respect to the resonance frequency of the solvent.

In some embodiments, the flip angles of the first and second radiofrequency pulses and/or the flip angles of the third and fourth radiofrequency pulses are different, such as to adjust a difference of the signal strengths of the nuclear magnetic resonance signals measured after the refocusing radiofrequency pulse, the differing signals originating from the nuclear spins excited by the (first) solute and the second solute, respectively.

For example, when the flip angles of the first and second radiofrequency pulses are different, the nuclear magnetic resonance signals originating from the (first) solute can be reduced, such as when the signal originating from the (first) solute is much larger than the signal originating from the second solute. Thus the weaker signal originating from the second solute may be measured at a higher resolution when the sampling step size is given by the measurement range.

In some embodiments, the second and third radiofrequency pulses may be combined into a single radiofrequency pulse with a larger bandwidth, and the respective measured signal strengths originating from the first and second solutes may then be modulated by changing the flip angle of the first and/or the fourth radiofrequency pulse.

In some embodiments, the method further permits detecting a second solute, wherein the preparation sequence further includes the steps of: applying a third radiofrequency pulse to a second nuclear spin at a resonance frequency of the second solute; and applying a third magnetic field gradient pulse suitable for changing a phase of the second nuclear spin; applying a fourth radiofrequency pulse to the second nuclear spin at a resonance frequency of the second solute; wherein a first separation time between the first radiofrequency pulse and the second radiofrequency pulse is different from a second separation time between the fourth radiofrequency pulse and the third radiofrequency pulse. Preferably, the measurement is configured to distinguish a first signal corresponding to the (first) solute and a second signal corresponding to the second solute according to different delays of the respective signals from the time of the refocusing radiofrequency pulse, the different delays being associated with the first separation time and the second separation time.

In some embodiments, the gradient pulse area of the first, second and third magnetic field gradient pulses are equal or deviating by 5% or less, preferably 1% or less, such as having the same gradient pulse area within the limitations of a gradient producing system.

In some embodiments, the choice of the applied gradient pulse areas of the first, second and/or third gradient pulses may be varied, and a fourth magnetic field gradient pulse may be applied after the third magnetic field gradient pulse, in order to selectively refocus the corresponding solute signals at different points in time during the data acquisition, wherein the gradient pulse area of the fourth magnetic field gradient pulse should correspond to the difference of the gradient pulse area of the third magnetic field gradient pulse and the first magnetic field gradient pulse or a gradient pulse area deviating from said difference by 10% or less, preferably 1% or less.

The stimulated echo due to the encoded excitation of the (first) solute or the second solute may be generated with a delay from the time of the refocusing radiofrequency pulse corresponding to the first separation time or the second separation time, respectively. The temporal separation of the generated signals can allow distinguishing between a signal from the first and the second solute.

Varying the phase instead of the separation time allows using the same optimal pulse separation time for both the first solute and the second solute. Varying the separation time may increase measurement sensitivity due to the temporal separation of the measured signals originating from the first and second solutes, respectively. Both techniques may be combined for achieving an advantageous compromise.

In some embodiments, the method further permits detecting a second nuclear spin located at a different exchange site of the solute as the (first) nuclear spin, wherein the preparation sequence further includes the steps of: applying a third radiofrequency pulse to the second nuclear spin at a resonance frequency of the different exchange site; and applying a third magnetic field gradient pulse suitable for changing a phase of the second nuclear spin; applying a fourth radiofrequency pulse to the second nuclear spin at a resonance frequency of the different exchange site; wherein a first separation time between the first radiofrequency pulse and the second radiofrequency pulse is different from a second separation time between the fourth radiofrequency pulse and the third radiofrequency pulse and/or wherein a phase of the fourth radiofrequency pulse is different from a phase of the third radiofrequency pulse.

Preferably, the measurement is configured to distinguish a first signal corresponding to the (first) nuclear spin and a second signal corresponding to the second nuclear spin according to the phases of the measured signals, the phases of the measured signals being encoded by the phase difference between the first and second radiofrequency pulses and the phase difference between the third and fourth radiofrequency pulses, and/or the measurement is configured to distinguish a first signal corresponding to the (first) nuclear spin and a second signal corresponding to the second nuclear spin according to different delays of the respective signals from the time of the refocusing radiofrequency pulse, the different delays being associated with the first separation time and the second separation time.

In some embodiments, the gradient pulse area of the first, second and third magnetic field gradient pulses are equal or deviating by 5% or less, preferably 1% or less, such as having the same gradient pulse area within the limitations of a gradient producing system.

In some embodiments, the choice of the applied gradient pulse areas of the first, second and/or third gradient pulses may be varied, and a fourth magnetic field gradient pulse may be applied after the third magnetic field gradient pulse, in order to selectively refocus the corresponding signals from nuclear spins excited at different exchange sites at different points in time during the data acquisition, wherein the gradient pulse area of the fourth magnetic field gradient pulse should correspond to the difference of the gradient pulse area of the second magnetic field gradient pulse and the first magnetic field gradient pulse or a gradient pulse area deviating from said difference by 10% or less, preferably 1% or less.

Hence, when a solute comprises a first and a second exchange site, whose resonance frequencies of the respective proton exchanged at the respective site are different, the method may detect a signal originating from two different exchange sites of the same solute at the same time.

In preferred embodiments, the measuring further comprises the step of applying a fifth magnetic field gradient pulse after the second magnetic field gradient pulse for reversing the evolution of the nuclear spins of the solvent induced by the second magnetic field gradient pulse, the gradient pulse area of the fifth magnetic field gradient pulse having the same magnitude as the gradient pulse area of the second magnetic field gradient pulse or a magnitude deviating by 5% or less, preferably by 1% or less, such as having the same gradient pulse area within the limitations of the gradient producing system.

The fifth magnetic field gradient pulse may reverse the evolution of the nuclear spins of the solvent induced by the second magnetic field gradient pulse and may therefore induce a chemically exchanged saturation transfer nuclear magnetic resonance signal of the solute. Hence, within the same measurement time, two complementary measurements of the solute may be performed.

The sign of the fifth magnetic field gradient pulse may depend on whether additional radiofrequency pulses are applied after the refocusing radiofrequency pulse and before the fifth magnetic field gradient pulse. For example, when no or an even number of π-pulses is applied after the refocusing pulse and before the fifth magnetic field gradient pulse, the fifth magnetic field gradient pulse should have opposite sign as the second magnetic field gradient pulse; whereas, when an odd number of π-pulses is applied after the refocusing pulse and before the fifth magnetic field gradient pulse, the fifth magnetic field gradient pulse should have the same sign as the second magnetic field gradient pulse.

In some embodiments, the measuring further comprises the step of performing an additional measurement of the saturation of the nuclear spins after applying the fifth magnetic field gradient pulse and/or of performing an additional measurement of the saturation of the nuclear spins before the nuclear spins have been selected by applying the second magnetic field gradient pulse, for retrieving a chemical exchange saturation transfer signal of the nuclear spins saturated by the at least one preparation sequence.

The additional measurement may retrieve the chemically exchanged saturation transfer nuclear magnetic resonance signal originating from the non-selected nuclear spins previously excited by the first radiofrequency pulse and effectively saturated by the at least one preparation sequence, when the second magnetic field gradient pulse is not applied or when its effect has been reversed, such as by applying the fifth magnetic field gradient pulse.

In a second aspect, the invention relates to a system for detecting a solute in a solvent using nuclear magnetic resonance comprising: an excitation module, the excitation module comprising a radiofrequency emitter configured to generate a radiofrequency pulse; and a gradient pulsing device configured to generate a magnetic field gradient. The excitation module is configured to encode an excitation in a nuclear spin of the solute by applying at least one preparation sequence. The preparation sequence comprises a first radiofrequency pulse at a resonance frequency of the solute; and a first magnetic field gradient pulse after the first radiofrequency pulse. The excitation module is further configured to apply a refocusing radiofrequency pulse at a resonance frequency of the solvent after the at least one preparation sequence; and a second magnetic field gradient pulse after the refocusing radiofrequency pulse, wherein the second magnetic field gradient pulse and the first magnetic field gradient pulse have the same gradient pulse area or a gradient pulse area deviating by 5% or less, preferably 1% or less, such as having the same gradient pulse area within the limitations of a gradient producing system.

The system may implement any combination of the methods described above.

In some embodiments, the system further comprises a sensor configured to measure an electromagnetic signal at a magnetic resonance frequency of the solvent. Preferably, the sensor is configured to perform a measurement of the excitation in the nuclear spin excited by the first radiofrequency pulse at the resonance frequency of the solute and refocused with the refocusing radiofrequency pulse at the resonance frequency of the solvent after the application of the second magnetic field gradient pulse.

In some embodiments, the radiofrequency emitter and the sensor is connected to a radiofrequency coil. In some embodiments, the radiofrequency emitter and the sensor are connected to the same radiofrequency coil.

In preferred embodiments, the system further comprises a means for generating a longitudinal magnetic field, in particular a longitudinal magnetic field coil and/or a material with a magnetic remanence.

In preferred embodiments, the excitation module applies a number of preparation sequences to encode the excitation and applies an equal number of second gradient pulses after the refocusing radiofrequency pulse, in particular wherein the number is greater than 1, preferably greater than 10, most preferably greater than 20, such as 80 or 100.

In preferred embodiments, the preparation sequence further comprises a second radiofrequency pulse at a resonance frequency of the solute, the second radiofrequency pulse being applied after the first magnetic field gradient pulse of the preparation sequence.

In preferred embodiments, the first and the second radiofrequency pulses produce the same flip angle or a flip angle deviating by 30% or less, preferably 10% or less, most preferably 5% or less. The first and the second radiofrequency pulses are in particular π/2-pulses or deviate from a π/2-pulse by π/4 or less, preferably π/6 or less, most preferably π/9 or less. The refocusing radiofrequency pulse (40) may be a π/2-pulse or may deviate from a π/2-pulse by π/4 or less, in particular π/6 or less, preferably π/9 or less.

In some embodiments, the preparation sequence further comprises a third magnetic field gradient pulse applied after the second radiofrequency pulse.

In some embodiments, the system further comprises means for implementing the methods or method steps described above or implements the above-mentioned pulsing and/or excitation sequences with the excitation module.

In some embodiments, the preparation sequence may comprise radiofrequency and/or gradient pulses corresponding to the radiofrequency and/or gradient pulses applied by any combination of the methods described above. The characteristics of the radiofrequency and/or gradient pulses may be the same as the characteristics introduced with reference to the various methods described above.

In the third aspect, the invention relates to a computer program or computer program product comprising computer readable instructions which, when executed by a computer, cause the computer to carry out a method with the step of encoding an excitation in a nuclear spin of the solute comprising at least one preparation sequence, wherein said preparation sequence comprises the steps of: applying a first radiofrequency pulse to the nuclear spin at a resonance frequency of the solute; and applying a first magnetic field gradient pulse suitable for changing a phase of the nuclear spin. The method further comprises the step of measuring the excitation in the nuclear spin, said measuring including the steps of: applying a refocusing radiofrequency pulse at a resonance frequency of the solvent for refocusing said nuclear spin transferred to the solvent by chemical exchange; applying a second magnetic field gradient pulse to thereby select the excitation in the nuclear spin; and performing a measurement of the excitation in the nuclear spin excited by the first radiofrequency pulse at the resonance frequency of the solute and refocused with the refocusing radiofrequency pulse at the resonance frequency of the solvent, wherein the second magnetic field gradient pulse and the first magnetic field gradient pulse have the same gradient pulse area or a gradient pulse area deviating by 10% or less, preferably 1% or less.

In some embodiments, the computer program or computer program product further comprises computer readable instructions to implement the steps of the methods described above or to control the systems or components of the systems described above.

### DETAILED DESCRIPTION OF EMBODIMENTS

The features and numerous advantages of the system and method according to the present invention will best be understood from a detailed description of preferred embodiments with reference to the accompanying drawings, in which:
- Fig. 1: is a schematic illustration of a nuclear magnetic resonance imaging system;
- Fig. 2: illustrates a nuclear magnetic resonance frequency spectrum of a solute and a solvent according to an example;
- Fig. 3: illustrates a flow diagram of a method to detect a solute in a solvent according to an example;
- Fig. 4: illustrates a schematic pulsing sequence to detect a solute in a solvent according to an example;
- Fig. 5: illustrates a schematic pulsing sequence to detect a solute in a solvent according to another example;
- Fig. 6: illustrates an exemplary measurement of a nuclear magnetic resonance signal acquired with a pulsing sequence corresponding to the example of Fig. 5;
- Fig. 7: illustrates an exemplary measurement of a nuclear magnetic resonance image acquired with a pulsing sequence corresponding to the pulsing sequence of Fig. 5 at a different pulsing frequency;
- Fig. 8: shows an exemplary spatially resolved nuclear magnetic resonance image of two samples containing a solute solved in a solvent with different concentrations using a pulsing sequence corresponding to the example of Fig. 5;
- Fig. 9: shows an application of a pulsing sequence for spatial and phase resolved nuclear magnetic resonance imaging of a solute in a solvent according to an example;
- Fig. 10: illustrates a schematic pulsing sequence to detect a solute in a solvent according to another example;
- Fig. 11: illustrates an exemplary spatially resolved nuclear magnetic resonance image of two samples containing two different solutes using a pulsing sequence corresponding to the example of Fig. 10;
- Fig. 12: illustrates a schematic pulsing sequence to detect a solute in a solvent according to yet another example;
- Fig. 13: illustrates a schematic pulsing sequence to detect a solute in a solvent according to yet another example; and
- Fig. 14: illustrates a frequency composition of a radiofrequency pulse according to an example by means of an exemplary solvent frequency spectrum.

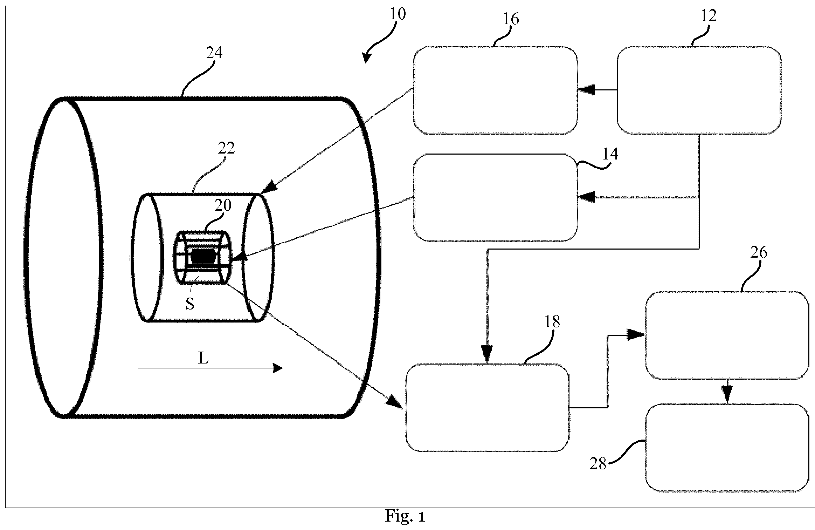

In the example of Fig. 1, a system 10 for nuclear magnetic resonance imaging is shown comprising an excitation module 12 which controls a radiofrequency emitter 14, a gradient pulsing device 16 and a sensor 18.

The radiofrequency emitter 14 can generate radiofrequency pulses of a defined duration and shape and is coupled to a radiofrequency coil 20. The radiofrequency coil 20 is shown in Fig. 1 as a birdcage coil, which can generate a rotating magnetic field component in a sample S along a transverse axis, which is transverse to the longitudinal direction L. However, different designs for the radiofrequency coil 20 may be used, such as a saddle coil, a solenoid coil, a Helmholtz coil and/or a TEM coil, as long as they allow generating an oscillating transverse magnetic field component in the sample S.

The gradient pulsing device 16 is coupled to gradient coils 22 and can be used to induce a magnetic field gradient having a gradient distribution across the sample S. The gradient coils 22 may be an assembly of magnetic field coils for producing a magnetic gradient field distribution, such as a linear change of the magnetic field, to induce a location dependent modification of the magnetic field within the sample S.

An external longitudinal magnetic field can be generated by the longitudinal magnetic field assembly 24, which may comprise magnets, shims, materials with a magnetic remanence and the like, to produce a longitudinal magnetic field with high field homogeneity.

A nuclear magnetic resonance signal can be captured by the sensor 18, which is shown in Fig. 1 to be coupled to the radiofrequency coil 20. Hence, the radiofrequency coil 20 may be used as an antenna for the radiofrequency emitter 14 as well as for the sensor 18. The signal may be digitized by the digitizer 26, such as an analog-to-digital converter, and may be transferred to a signal processing device 28 to process the measured signal.

The system 10 is suitable for conventional nuclear magnetic resonance imaging, but in the following its use for detecting a solute solved in a solvent of the sample S by exploiting the chemical exchange of a proton of the solute with the solvent will be described.

Chemical exchange as referred to herein relates to a process wherein a nuclear spin, such as a nuclear spin of a proton of a hydrogen atom, is exchanged between a molecule of the solute and a molecule of the solvent, such as water, by a chemical process. Hence, in the following description, the solute is chosen such that it performs chemical exchange of a proton with the solvent.

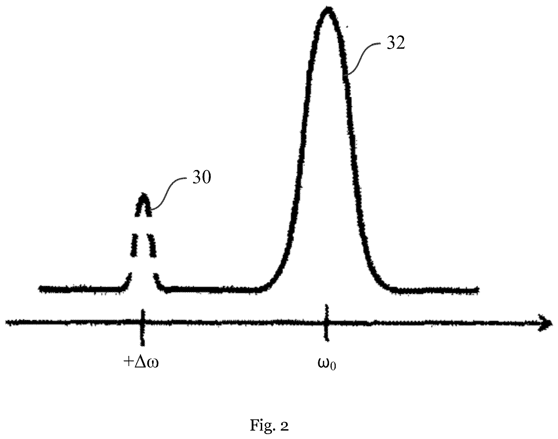

Furthermore, the proton of the solute, which is chemically exchanged with the solvent, may show a chemical shift +Δω of its resonance 30 with respect to the resonance frequency ωₒ of the solvent at the resonance 32 of the solvent, as shown in Fig 2. The chemical shift +Δω may originate from an interaction of electrons in the molecular orbital of the solute with the external magnetic field, which modifies the local magnetic field experienced by the nuclear spin of the proton.

Preferably, the resonance of the solute 30 has a low overlap with the resonance of the solvent 32 as shown in Fig. 2, to limit the probability of a spurious excitation of the solvent when exciting the solute, and vice versa. The chemical shift of the solute depends on the magnitude of the externally applied longitudinal magnetic field. Hence, the magnitude of the external longitudinal magnetic field may be chosen such that the resonance of the solute 30 has a low or zero overlap with the resonance of the solvent 32.

The chemical exchange rate, at which a proton is on average transferred from the solute to the solvent, should be smaller than the chemical shift +Δω, such that the condition of a slow to intermediate exchange is fulfilled, which may allow a selective excitation of the solute.

Examples for the solute are metabolites or molecules, which may also be suitable for chemical exchange saturation transfer imaging, such as iopamidol, glucose, glutamate, creatine, L-argentine, glycosaminoglycans, barbiture acid, thymidine, adenosine, gamma-aminobutyric acid, glycine, myo-inositol, human protamine, or derivates thereof. The solvent may be suitable for chemical exchange saturation transfer imaging, such as water for biomedical diagnosis.

The chemical shift +Δω of the solute may allow a selective excitation of the nuclear spin of the solute by exciting the sample with a radiofrequency pulse at the resonance frequency of the solute.

When the proton of the solute is transferred to the solvent, an excitation excited in the solute can be transferred to the solvent. The proton transferred from the solvent to the solute in return may be aligned along the longitudinal magnetic field direction. Therefore, the solute may be continuously excited to spread the excitation to a plurality of molecules of the solvent in the vicinity of one molecule of the solute. Hence, by repeatedly exciting one molecule of the solute, a plurality of molecules of the solvent can be excited, thereby increasing the possible signal generated from one molecule of the solvent.

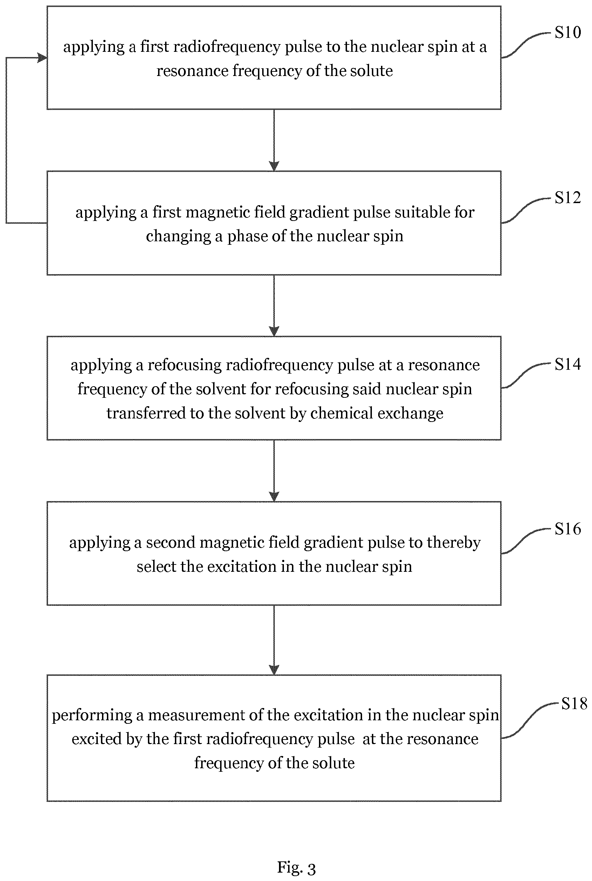

This property may be exploited to implement the method illustrated by the flow diagram depicted in Fig. 3 to detect a solute in the solvent using nuclear magnetic resonance. The method comprises a preparation or excitation sequence 34 to encode an excitation in a nuclear spin of the solute with the steps of applying a first radiofrequency pulse 36 to the nuclear spin at a resonance frequency of the solute (step S10), and applying a first magnetic field gradient pulse 38 suitable for changing a phase of the nuclear spin (step S12). The preparation sequence 34 may be repeated to excite a plurality of solvent molecules. In the following, the excitation in the nuclear spin is measured by applying a refocusing radiofrequency pulse 40 at a resonance frequency of the solvent for refocusing said nuclear spin transferred to the solvent by chemical exchange (step S14), and applying a second magnetic field gradient pulse 44 to thereby select the excitation in the nuclear spin (step S16). The excitation can be measured by performing a measurement 46 of the excitation in the nuclear spin excited by the first radiofrequency pulse 36 at the resonance frequency of the solute (step S18).

The excitation module 12 can be used to generate the radiofrequency and magnetic field gradient pulses 36, 38, 40, 44. The first magnetic field gradient pulse 38 may imprint a location specific phase change onto the nuclear spins excited by the first radiofrequency pulse 36. In the example shown, the gradient pulse area is chosen, such that the nuclear spins of the sample S are dephased after the first gradient pulse 38. By applying the refocusing radiofrequency pulse 40, an echo (e.g. spin echo, stimulated echo, echo of higher order) of a previous excitation can be produced. The second magnetic field gradient pulse 44 may allow selecting the previously encoded excitation in the spin, while dephasing any spurious excitation created during the method.

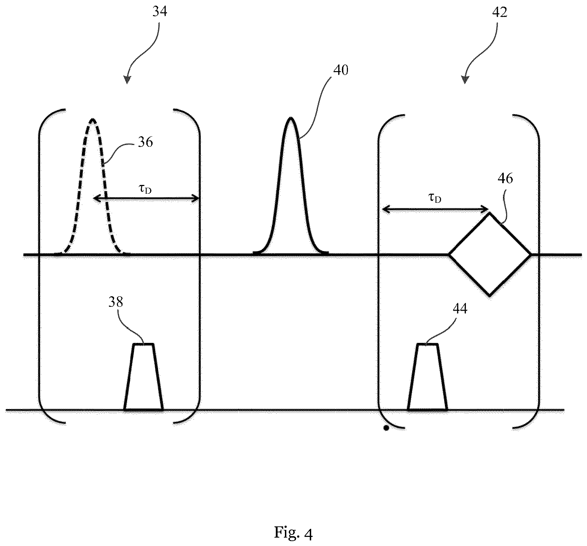

A first example of a pulsing sequence to implement the method shown in Fig. 3 is illustrated in Fig. 4. The pulsing sequence comprises a preparation sequence 34, which includes the first radiofrequency pulse 36 and the first magnetic field gradient pulse 38 and a time delay τ_{D}. For brevity of discussion, the first radiofrequency pulse 36 is considered to be a π/2-pulse, even though other pulses may be used and deviations from a π/2-pulse are possible.

The π/2-pulse changes the spin orientation of a nuclear spin of the solute from an initially longitudinal orientation to a transverse orientation.

To selectively excite mostly the nuclear spins of the solute, the bandwidth and shape of the first radiofrequency pulse 36 should be carefully chosen. The bandwidth of the first radio frequency pulse 36 should be smaller than the chemical shift +Δω of the solute with respect to the solvent to avoid a spurious excitation of the protons of the solvent, such as between 200 and 2000 Hz and may have a pulse length of between 1 and 10 ms. A shape of the first radiofrequency pulse 36 may be chosen from a Gaussian, Sine, Burp, Fermi, Hermite, or composite pulses, such as binomial pulses, or the like and may be chosen to have a small bandwidth-pulse length product.

Due to the externally applied longitudinal magnetic field, the nuclear spin of the solute having a transverse spin component precesses around the longitudinal magnetic field direction with the Larmor frequency, wherein the Larmor frequency depends on the strength of the externally applied magnetic field.

The first magnetic field gradient pulse 38 modifies the spatial dependence of the magnetic field strength across the sample S. Hence, the first magnetic field gradient pulse 38 locally changes the effective Larmor frequency. The modification of the precession frequency may effectively lead to a change of the phase of the nuclear spin of the solute. Therefore, during the duration of the first magnetic field gradient pulse 38, the nuclear spins excited by the first radiofrequency pulse 36 may be encoded with a predictable and location specific change in their phase by the first magnetic field gradient pulse 38.

The amplitude of the first magnetic field gradient pulse 38 may be chosen to dephase the nuclear spins, such that, after the first magnetic field gradient pulse 38, the net magnetization of the nuclear spins excited by the first radiofrequency pulse 36 may be zero. A duration of the first magnetic field gradient pulse 38 may be chosen accordingly, such as a duration between 0.1 ms and 2 ms.

Following the first radio frequency pulse 36 and/or the first magnetic field gradient pulse 38, the preparation sequence 34 comprises the time delay τ_{D} to allow the solute to chemically exchange with the solvent. Therefore, during the time delay τ_{D}, the encoded excitation may be transferred to the solvent. The time delay τ_{D}, may be chosen depending on the exchange rate of the solute and may be equal, shorter, or longer than the inverse of the exchange rate of the solute (the average exchange time), such as a time delay τ_{D} between 5 ms and 150 ms.

The preparation sequence 34 may be repeated to transfer an excitation to a plurality of molecules of the solvent.

Following the at least one preparation sequence 34, the refocusing radiofrequency pulse 40 is applied to the sample S. In the example of Fig. 4, the refocusing radiofrequency pulse 40 is a π-pulse, which rotates the nuclear spin around a transverse axis by an angle of π. Hence, a previous evolution of the nuclear spin around the longitudinal axis L may be effectively reversed.

The refocusing radiofrequency pulse 40 may therefore reverse an evolution due to an inhomogeneity of the effective magnetic field and thereby produce a so called spin echo at a point in time spaced from the refocusing radiofrequency pulse 40 by the delay between the initial excitation by the preparation sequence 34 and the refocusing radiofrequency pulse 40.

The refocusing radiofrequency pulse 40 may have a larger bandwidth than the first and/or the second radiofrequency pulse 36, 48, such as between 200 Hz and 20 kHz. A duration of the refocusing radiofrequency pulse 40 may be similar to the first and second radiofrequency pulses 36, 48, such as 0.5 ms to 10 ms. The shape of the refocusing radiofrequency pulse 40 may be similar to the shape of the first and second radiofrequency pulses 36, 48 and may be chosen according to a slice profile quality of a nuclear magnetic resonance imaging system, such as a Gaussian, Sinc or Hermite shape.

To reverse the evolution due to the first magnetic field gradient pulse 38 and filter the nuclear spins excited by the preparation sequence 34, a second magnetic field gradient pulse 44 is applied. The second magnetic field gradient pulse 44 has the same gradient pulse area and gradient distribution as the first magnetic field gradient pulse. Therefore, in each spatial position of the sample S, the nuclear spins, whose phase has been modified by the first magnetic field gradient pulse 38, acquire a phase through the application of the second magnetic field gradient pulse 44, which, in combination with the refocusing radiofrequency pulse 40, reverses the effect of the first magnetic field gradient pulse 38.

In particular, when a number of preparation sequences 34 is applied, an equal number of second magnetic field gradient pulses 44 can be applied to create a measuring sequence 42, with a sequence of measurements 46, to measure a number of spin echoes, which may be equal to the number of preparation sequences 34.

The timing of the spin echoes can be fully deterministic. Hence, the measurements 46 may be performed at the time of the spin echoes and the signal can be summed to obtain a nuclear magnetic resonance signal of the solute. A total duration for obtaining a signal with the pulsing sequence of Fig. 4 may be lower than a total duration of a conventional measurement of the nuclear magnetic resonance signal of the solute.

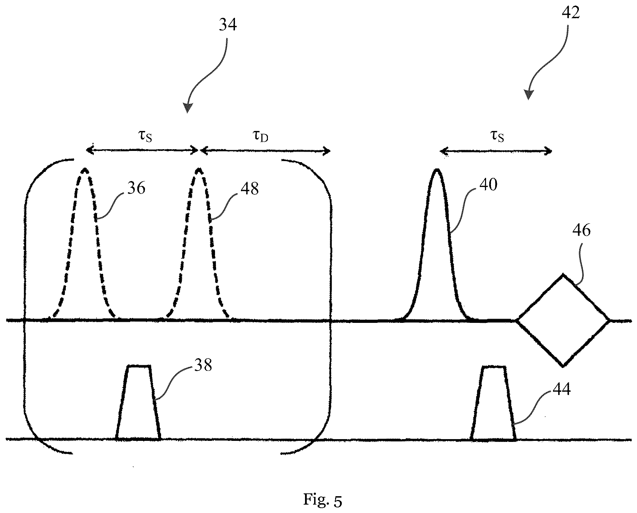

Another example of a pulsing sequence to implement the method of Fig. 3 is shown in Fig. 5. The illustrated pulsing sequence also comprises a preparation sequence 34 with a first radiofrequency pulse 36, followed by a first magnetic field gradient pulse 38 and a second radiofrequency pulse 48 delayed from the first radiofrequency pulse 36 by a separation time τ_{S}. The preparation sequence 34 further comprises a time delay τ_{D} to allow the encoded excitation to be chemically exchanged with the solvent. The time separation τ_{S} between the first radiofrequency pulse 36 and the second radiofrequency pulse 48 should be suitable to encode the excitation, such as a separation time τ_{S} between 2 ms and 20 ms.

For brevity of discussion, the first and second radiofrequency pulses 36, 48 are considered to be π/2-pulses, even though other pulses may be used and deviations from a π/2-pulse are possible. The first magnetic field gradient pulse 38 may be chosen as in the previous example.

Hence, as described with reference to Fig. 4, a nuclear spin of the solute acquires a transverse spin component due to the first radiofrequency pulse 36, whose phase is predictably modified by the first magnetic field gradient pulse 38. The second radiofrequency pulse 48 may then project the nuclear spin onto the longitudinal direction. Hence, an excitation by the first radiofrequency pulse 36 and the first magnetic field gradient pulse 38 may be stored in the longitudinal spin orientation. Following the application of the second radiofrequency pulse 48, an effect of magnetic field gradients onto the nuclear spin may therefore be reduced.

As described with reference to Fig. 4, the preparation sequence 34 may be repeated to chemically transfer a plurality of excitations encoded in the solute to the solvent.

The plurality of preparation sequences 34 is then followed by a measurement sequence 42, comprising a refocusing radiofrequency pulse 40, a second magnetic field gradient pulse 44 and a measurement 46.

In contrast to the refocusing radiofrequency pulse 40 of Fig. 4, the refocusing radiofrequency pulse 40 of the measurement sequence 42 in Fig. 5 is considered to be a π/2-pulse. The refocusing radiofrequency pulse 40 may then, in combination with the second radiofrequency pulse 48 of the preparation sequence 34, also result in an effective reversal of the evolution of the nuclear spin.

However, instead of a sequence of spin echoes, the pulsing sequence of Fig. 5 may induce a stimulated echo with a temporal spacing from the refocusing radiofrequency pulse 40 which is equal to the separation time τ_{S}. Hence, the point in time of the stimulated echo may be independent of the temporal separation between the preparation sequence 34 and the refocusing radiofrequency pulse 40. Therefore, the signal from a number of preparation sequences 34 can constructively overlap at the point in time of the stimulated echo and can be measured with the measurement 46.

To reverse the effect of the first magnetic field gradient pulse 38, the second magnetic field gradient pulse 44 is used, which, analogous to the second magnetic field gradient pulse 44 of Fig. 4, may have an equal gradient pulse area as the first magnetic field gradient pulse 38.

As the measurement 46 may measure the sum of the nuclear magnetic resonance signal from the excitations generated by a plurality of preparation sequences 34, a signal to noise ratio of the pulsing sequence may be increased. The second magnetic field gradient pulse 44 may select the excitation generated by the preparation sequences 34, while at the same time suppressing spurious excitations generated by the preparation sequences 34 or the refocusing radio frequency pulse 40, and may therefore be considered to be a filter for the excitation generated by the preparation sequences 34.

For the sake of brevity, the pulsing sequence of Fig. 5 may in the following be referred to as the Remote Acquisition of Chemically Exchange Transferred Excitations (RACETE).

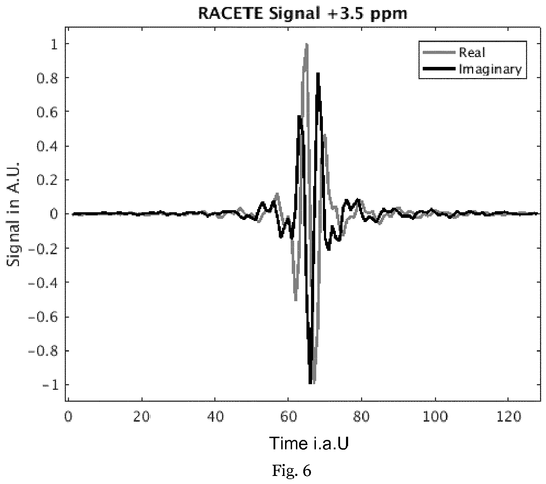

A measurement of a nuclear magnetic resonance signal acquired with the RACETE technique from a solution of Barbituric Acid in water with a concentration of 62,5 mmol/L performed in a Bruker 500 MHz 11,7 T Spectrometer is shown in Fig. 6. The nuclear spin of the proton of Barbituric Acid in the exemplary measurement has a relative chemical shift from the resonance frequency ωₒ of water greater than +3.5 ppm. The relative chemical shift may be the chemical shift +Δω of the resonance frequency of Barbituric Acid with respect to the resonance frequency ωₒ of water, divided by the resonance frequency ωₒ of water. The chemical shift +Δω depends on the externally applied magnetic field strength. For example, the relative chemical shift of 3.5 ppm may correspond to a chemical shift +Δω of 1750Hz at an external magnetic field of 11,7 T.

The measurement shows the real and the imaginary part of the measured signal intensity as a function of the time. As can be seen, a clear signal is produced at a specific point in time and the intensity and spatial resolution allows directly measuring the magnitude and the phase of the generated signal.

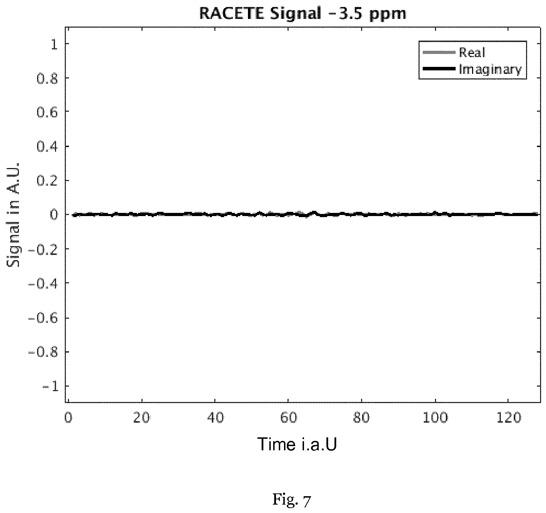

To investigate the origin of the signal measured in Fig. 6, the measurement is repeated in Fig. 7, wherein the frequency of the first and second radiofrequency pulses 36, 48 are chosen to be at an offset of -3.5 ppm with respect to the resonance frequency ωₒ of water. As can be seen from Fig. 7, no signal is observed, when the preparation sequence 34 does not encode an excitation in the solute by choosing an incorrect frequency for the first and second radiofrequency pulses 36, 48.

The RACETE technique may be combined with conventional nuclear magnetic resonance imaging techniques to obtain a two-dimensional image (slice) of the investigated sample. The technique may therefore be combined with imaging gradients known from the state of the art to derive a spatial origin of the measured signal.

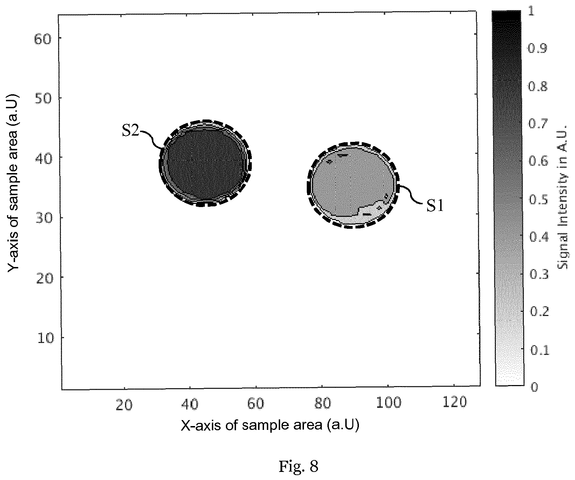

A corresponding measurement of a two-dimensional slice of a sample area is shown in Fig. 8. Two circular samples S1, S2 with different concentrations of Barbituric Acid, whose approximate location is indicated by dashed contours in the measurements, are placed inside the sample area. The first sample S1 has a concentration of Barbituric Acid of 15.6 mmol/L, while the second sample S2 has a concentration of Barbituric Acid of 62.5 mmol/L. The axes correspond to an X-axis and a Y-axis of the sample area and are shown with arbitrary units. The length of both axes in the measurement of Fig. 8 is 2 cm. The intensity may be the absolute value of the real and imaginary values of the measured signal at the time of the stimulated echo of the RACETE technique. As can be seen from Fig. 8, both samples S1, S2 with different concentrations can be imaged in the measurement and may be detected with the correct shape and the respective concentration may be derived from the magnitude of the signal.

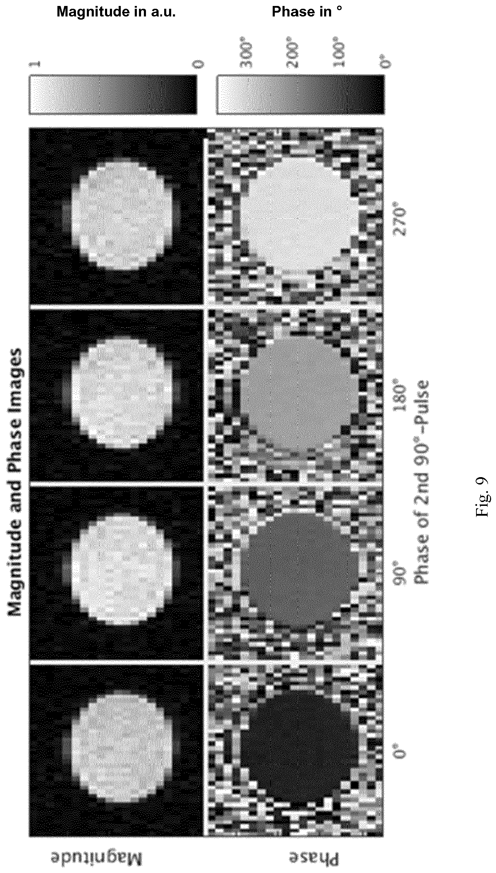

A further feature of the RACETE technique is shown in Fig. 9. In Fig. 9, the measurement sequence of Fig. 5 is repeated to obtain a two-dimensional slice of a sample area of a third sample S3 of Iopamidole with a concentration of 525 mmol/L. Fig. 9 shows eight nuclear magnetic resonance images of the third sample S3 acquired with the RACETE technique. In the upper row, the magnitude i.e. the absolute value of the signal is shown. In the lower row, the phase of the signal is shown. From the left to the right, a phase offset of the second radiofrequency pulse 48 with respect to the first radio frequency pulse 36 is varied in steps of 90°. As can be seen in Fig. 9, the phase offset between the first and the second radiofrequency pulse 36, 48 is encoded by the preparation sequence 34 and may be recovered through an analysis of the signal measured at the time of the measurement 46.

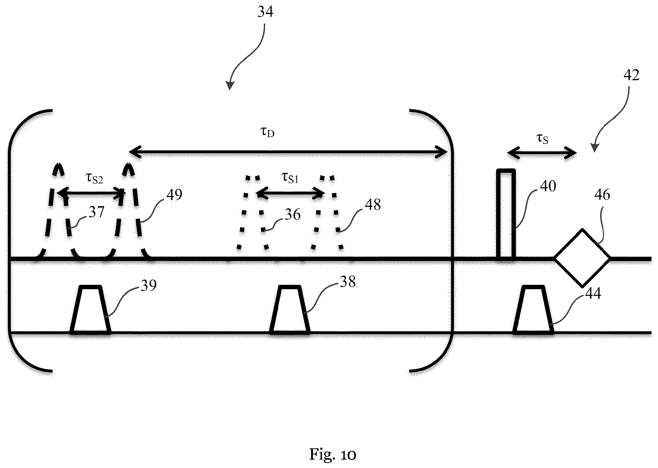

The filtering effect of the second magnetic field gradient pulse 44 in combination with the preparation sequence 34 and the sensitivity to the phase of the signal may be used to detect a second solute at the same time. Fig. 10 shows a modified RACETE sequence, wherein the preparation sequence further comprises a third radiofrequency pulse 37 and a fourth radiofrequency pulse 49.

The third and fourth radiofrequency pulses 37, 49 may be radiofrequency pulses at a frequency of the second solute and may have similar shapes, bandwidths and/or durations as the first and second radiofrequency pulses 36, 48. Hence, the third and fourth radiofrequency pulses 37, 49 may equally be considered to be π/2-pulses in the following.

Between the third and fourth radiofrequency pulses 37, 49, a third magnetic field gradient pulse 39 may be applied to encode an excitation in the second solute. Preferably, the third magnetic field gradient pulse 39 has an equal gradient pulse area. Then, the encoded excitation may be selected with the second magnetic field gradient pulse 44 after the refocusing radiofrequency pulse 40.

The time interval between the third and fourth radiofrequency pulses 37, 49 and the time interval between the first and second radiofrequency pulses 36, 48 may overlap. Then, the third magnetic field gradient pulse 39 may be the first magnetic field gradient pulse 38 and the same gradient pulse may be used to encode an excitation in the nuclear spin of the (first) solute and the second solute.

When the first separation time τ_{S1} between the first and the second radiofrequency pulses 36,48 and the second separation time τ_{S2} between the third and the fourth radiofrequency pulses 37,49 are equal, such as having the same separation time τ_{S}, the magnetic resonance signal originating from the first and second solutes may be refocused simultaneously as shown in Fig. 10. To distinguish a signal originating from the first and the second solute in the measurement 46, the nuclear spins of the first and the second solute may be encoded with a different phase. The third and fourth radiofrequency pulses 37, 49 may have a different phase difference as the first and second radiofrequency pulses 36, 48. For example, the phase of the third and fourth radiofrequency pulses 37, 49 may differ by a phase of π. Then, the signal of the first and the second solute may be distinguished by their difference in the phase.

However, the second separation time τ_{S2} between the third and fourth radiofrequency pulses 37, 49 may also be different from the first separation time τ_{S1} between the first and second radiofrequency pulses 36, 48. Then the stimulated echoes from the encoded excitations of the first and the second solute may be separated in time according to the respective separation times τ_{S1}, τ_{S2}, and may hence be individually measured.

Naturally, this technique may be extended towards an arbitrary number of simultaneously measured solutes, each excited with respective radiofrequency pulse pairs 36,37,48,49 having different phase differences and/or separation times τ_{S1}, τ_{S2}.

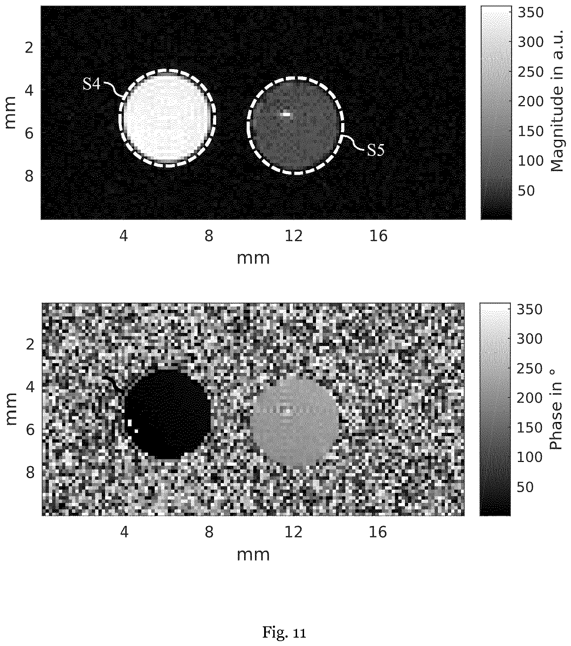

An illustrative measurement of a two-dimensional slice of a sample area with two samples S4, S5 containing different solutes is shown in Fig. 11, wherein the approximate location of the respective samples S4, S5 is indicated by dashed white contours in the upper measurement. The axes correspond to an X-axis and a Y-axis of the sample area. The fourth sample S4 comprises a solution of Iopamdiol with a concentration of 520 mmol/L and the fifth sample S5 comprises a solution of Barbituric Acid with a concentration of 62.5 mmol/L.

The measurement of Fig. 11 is performed using the pulse sequence illustrated in Fig. 10 in a longitudinal magnetic field of 17.5 Tesla, corresponding to a solvent proton frequency of 746 MHz. The first and second radiofrequency pulses 36, 48 are applied at the resonance frequency of an exchange site of Iopamidol with a frequency offset from the solvent frequency of 4250 Hz, corresponding to a relative chemical shift of 5.69 ppm. No phase shift between the first and second radio frequency pulse 36, 48 is introduced. The third and fourth radiofrequency pulses 37, 49 are applied at the resonance frequency of an exchange site of Barbituric Acid with a frequency offset from the solvent frequency of 4800 Hz, corresponding to a relative chemical shift of 6.43 ppm. However, unlike for the first and second radiofrequency pulses 36, 48, a phase shift between the third and fourth radio frequency pulses 37, 49 of 180° is introduced. The bandwidth of the first, second, third and fourth radiofrequency pulses 36, 37, 48, 49 is 600 Hz.

The upper measurement shows the magnitude of the measured signal in the sample area. As can be seen in Fig. 11, both samples S4, S5 may be clearly identified within the same measurement. The lower measurement shows the phase of the measured signal within the same sample area and acquired with the same measurement. The fourth sample S4 creates a clear footprint within the phase measurement, corresponding to a circular area with a phase of 0° in the same position as the corresponding magnitude signal in the magnitude measurement above. Similarly, the phase signal originating from the fifth sample S5 is associated with a circular area having a phase shift of roughly 180°, and which is located at the position of the fifth sample S5 as identified by the magnitude measurement above.

The information from the phase measurement may be used to distinguish the two (or more) different solutes within the same measurement. As a consequence, the spatial distribution of two different solutes in the sample area may be acquired twice as fast as in the case of selective excitation of each solute and a corresponding individual (magnitude) measurement of the respective solutes.

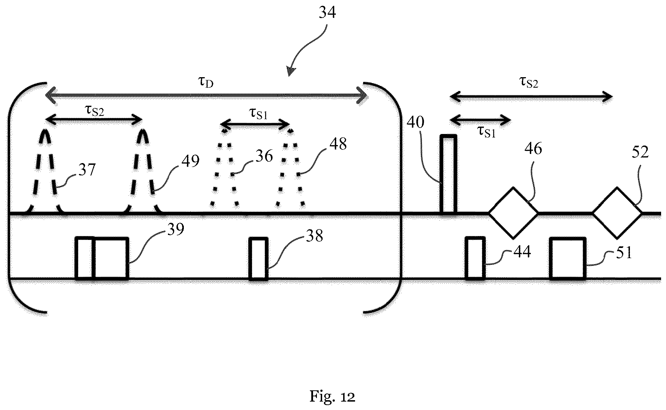

Fig. 12 illustrates a further modified pulsing sequence using the RACETE technique to detect a first and a second solute within the same measurement. The preparation sequence 34 with the duration τ_{D} comprises a first and a second radiofrequency pulse 36, 48 at the resonance frequency of the first solute spaced by the first separation time τ_{S1} and with a first magnetic field gradient pulse 38 applied between the pulses 36, 48. The preparation sequence 34 further comprises a third and a fourth radiofrequency pulse 37, 49 at the resonance frequency of the second solute spaced by the second separation time τ_{S2} and with a third magnetic field gradient pulse 39 applied between the radiofrequency pulses 37, 49.

The first and second radiofrequency pulses 36, 48 as well as the third and fourth radiofrequency pulses 37, 49 may induce substantially the same flip angle, respectively, and are preferably π/2-pulses as described in the previous examples. In the example of Fig. 12, the gradient pulse area of the first magnetic field gradient pulse 38 is shown to be smaller than the gradient pulse area of the third magnetic field gradient pulse 39, and the second separation time τ_{S2} is shown to be longer than the first separation time τ_{S1}, and the pulsing sequence will be described with this configuration, even though the skilled person will appreciate that any separation times τ_{S1}, τ_{S2} and/or gradient pulse areas may be chosen.

Following the application of at least one preparation sequence 34, the refocusing radiofrequency pulse 40 at the resonance frequency ωₒ of the solvent can be applied to measure the excitation encoded by the preparation sequence 34.

For refocusing and selecting the nuclear spins encoded with an excitation during the first and second radiofrequency pulses 36, 48, the second magnetic field gradient pulse 44 is applied after the refocusing radiofrequency pulse 40. The second magnetic field gradient pulse 44 should have a gradient pulse area substantially equal to the gradient pulse area of the first magnetic field gradient pulse 38, or deviating from the pulse area of the first magnetic field gradient pulse 38 by 5% or less, preferably 1% or less. Then a stimulated echo occurs at the measurement 46 at a time corresponding to the duration τ_{S1} after the application of the refocusing radiofrequency pulse 40.

For refocusing and selecting the nuclear spins encoded with an excitation during the third and fourth radiofrequency pulses 37, 49, the fourth magnetic field gradient pulse 51 is applied after the measurement 46. The fourth magnetic field gradient pulse 51 should have a gradient pulse area corresponding to the difference of the gradient pulse area of the third magnetic field gradient pulse 39 and the second magnetic field gradient pulse 44, or deviating from said difference by 5% or less, preferably 1% or less. Then a stimulated echo occurs at the second measurement 52 at a time corresponding to the duration τ_{S2} after the application of the refocusing radiofrequency pulse 40.

If the gradient pulse area of the first magnetic field gradient pulse 38 is larger than the third magnetic field gradient pulse 39, the difference of the gradient pulse area of the first magnetic field gradient pulse 38 and the second magnetic field gradient pulse 44 may be negative. Hence, the fourth magnetic field gradient pulse 51 may have opposite sign as the second magnetic field gradient pulse 44. However, the skilled person will appreciate, that the sign of the fourth magnetic field gradient pulse 51 may be modified if additional radiofrequency pulses (not shown) are applied between the second and fourth magnetic field gradient pulses 44, 51, such as a π-pulse.

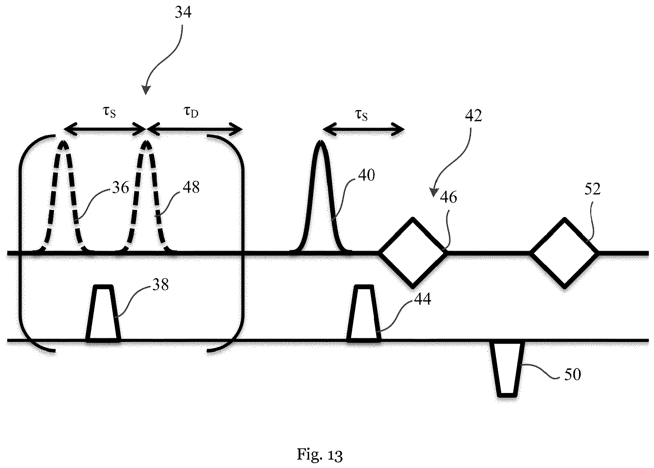

A further modified pulse sequence using the RACETE technique to detect a solute in a solvent is shown in Fig. 13. The pulsing sequence corresponds to the pulsing sequence of Fig. 5, but additionally comprises a fifth magnetic field gradient pulse 50 after the measurement 46 and an additional measurement 52 after the fifth magnetic field gradient pulse 50.

In Fig. 13, the fifth magnetic field gradient pulse 50 preferably has equal magnitude as the first and second magnetic field gradient pulses 38, 44 but opposite sign. Therefore, the fifth magnetic field gradient pulse 50 can reverse the effect of the second magnetic field gradient pulse 44 on to the nuclear spins of the solvent.

Without the effect of the second magnetic field gradient pulse 44, the preparation sequences 34 may effectively create a saturation of the nuclear spins of the solute. The saturation of the nuclear spins of the solute may then be transferred to the solvent by chemical exchange.

Hence, when the effect of the second magnetic field gradient pulse 44 is reversed by the fifth magnetic field gradient pulse 50, the additional measurement 52 may effectively measure a conventional chemical exchange saturation transfer (CEST) signal. Thus, by applying the fifth magnetic field gradient pulse 50 after the measurement 46, it is possible to combine the conventional chemical exchange saturation transfer technique with the RACETE technique for obtaining a measurement with both techniques at the same time.

Additionally, the conventional chemical exchange saturation transfer signal may be measured directly after the refocusing radiofrequency pulse 40, before the second magnetic field gradient pulse 44 is applied. However, the conventional CEST signal may have a significantly larger amplitude than the signal produced by the RACETE technique directly after the refocusing radiofrequency pulse 40, such that a greater measurement range may be required for the detection circuit. By using the fifth magnetic field gradient pulse 50, the conventional CEST signal may be recovered after applying the second magnetic field gradient pulse 44, such that the conventional CEST signal may be measured after a significant reduction of its signal strength originating from longitudinal (T1) relaxation of the excited solvent spins. Therefore, the technical requirements of the measurement range of the signal acquisition hardware for the pulse sequence of Fig. 13 may be lower than in the case of a composite measurement with a direct measurement of the CEST signal after the refocusing radiofrequency pulse.

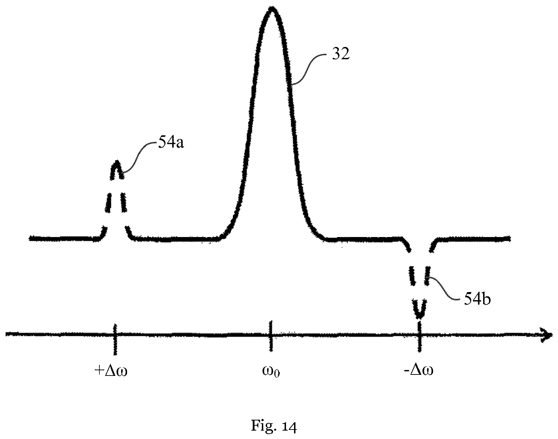

To suppress a spurious excitation of the solvent by the radiofrequency pulses 36, 37, 48, 49 the pulse shape of the excitation radiofrequency pulses 36, 37, 48, 49 may be modified. In particular, the radiofrequency pulses 36, 37, 48, 49 may have several pulse components 54a, 54b as shown by Fig. 14 to form a composite pulse.

In Fig. 14, the solid line shows a conventional magnetic resonance intensity of the solvent as a function of excitation frequency at the resonance frequency ωₒ. Additionally, a first pulse component 54a and a second pulse component 54b of an exemplary pulse are shown by a dashed line.

The first pulse component 54a may correspond to an excitation at the magnetic resonance of the solute 30. The second pulse component 54b may correspond to an excitation at a frequency that has the same offset as the first pulse component from the magnetic resonance 32 of the solvent, but with an opposite sign. The flip angle induced by the second pulse component 54b of the pulse may be equal to the flip angle induced by the first pulse component 54a. However, a phase of the second pulse component 54b may be shifted by a phase shift of π with respect to a phase of the first pulse component 54a. Thus, a spurious excitation of the solvent by the first pulse component 54a may be reversed by the second pulse component 54b.

It is further noted that, even though the radiofrequency excitations applied to the nuclear spins have been referred to herein as radiofrequency pulses 36, 37, 40, 48, 49 according to a best mode of carrying out the invention, the described pulses 36, 37, 48, 49 may be replaced with composite radiofrequency pulses and/or radiofrequency pulse trains which are suitable to induce the described nuclear spin rotations.

The description of the preferred embodiments and the Figures merely serve to illustrate the invention and the beneficial effects associated therewith, but should not be understood to imply any limitation. The scope of the invention is to be determined solely by the appended claims.

### LIST OF REFERENCE SIGNS

10 system
12 excitation module
14 radiofrequency emitter
16 gradient pulsing device
18 sensor
20 radiofrequency (RF) coil
22 gradient coils
24 longitudinal magnetic field assembly
26 digitizer
28 signal processing device
30 resonance of the solute
32 resonance of the solvent
34 preparation sequence
36 first radiofrequency pulse
37 third radiofrequency pulse at the frequency of the second solute
38 first magnetic field gradient pulse
39 third magnetic field gradient pulse
40 refocusing radiofrequency pulse
42 measuring sequence
44 second magnetic field gradient pulse
46 measurement
48 second radiofrequency pulse
49 fourth radiofrequency pulse
50 fifth magnetic field gradient pulse
51 fourth magnetic field gradient pulse
52 additional measurement
54a first pulse component
54b second pulse component
S Sample
S1/S2/S3/S4/S5 first/second/third/fourth/fifth sample
L longitudinal direction
ωₒ resonance frequency of the solvent
+Δω chemical shift of the solute
-Δω offset of the second pulse component
τ_{D} time delay
τ_{S} separation time
τ_{S1} first separation time
τ_{S2} second separation time

## Claims

1. A method of detecting a solute in a solvent using nuclear magnetic resonance, wherein the solute performs chemical exchange of a proton with the solvent, said method comprising the steps of:
encoding an excitation in a nuclear spin of the solute comprising at least one preparation sequence (34), wherein said preparation sequence (34) comprises the steps of:
- applying a first radiofrequency pulse (36) to the nuclear spin at a resonance frequency of the solute (S10); and
- applying a first magnetic field gradient pulse (38) suitable for changing a phase of the nuclear spin (S12); and
measuring the excitation in the nuclear spin, said measuring including the steps of:
- applying a refocusing radiofrequency pulse (40) at a resonance frequency of the solvent for refocusing said nuclear spin transferred to the solvent by chemical exchange (S14);
- applying a second magnetic field gradient pulse (44) to thereby select the excitation in the nuclear spin (S16); and
- performing a measurement (46) of the excitation in the nuclear spin excited by the first radiofrequency pulse (36) at the resonance frequency of the solute and refocused with the refocusing radiofrequency pulse (40) at the resonance frequency of the solvent (S18),
wherein the second magnetic field gradient pulse (44) and the first magnetic field gradient pulse (38) have the same gradient pulse area or a gradient pulse area deviating by 10% or less, preferably 1% or less.

2. The method of claim 1, wherein the first radiofrequency pulse (36) is a π/2-pulse or deviating from a π/2-pulse by π/4 or less, in particular π/6 or less, preferably π/9 or less.

3. The method of claim 1 or 2, wherein the preparation sequence (34) further comprises the step of:
applying a second radiofrequency pulse (48) at the resonance frequency of the solute after applying the first magnetic field gradient pulse (38).

4. The method of claim 3, wherein the first and the second radiofrequency pulses (36,48) produce the same flip angle or a flip angle deviating by 30% or less, preferably 10% or less, most preferably 5% or less, wherein the first and the second radiofrequency pulses (36,48) are preferably π/2-pulses or deviating from a π/2-pulse by π/4 or less, preferably π/6 or less, most preferably π/9 or less and/or wherein the refocusing radiofrequency pulse (40) is preferably a π/2-pulse or deviating from a π/2-pulse by π/4 or less, in particular π/6 or less, preferably π/9 or less.

5. The method of claim 3 or 4, which further permits detecting an excitation in a second nuclear spin of a second solute and/or an excitation in a second nuclear spin located at a different exchange site of the solute as the exchange site of the nuclear spin, wherein the preparation sequence further includes the steps of:
- applying a third radiofrequency pulse (37) to the second nuclear spin at a resonance frequency of the second nuclear spin; and
- applying a third magnetic field gradient pulse (39) suitable for changing a phase of the second nuclear spin;
- applying a fourth radiofrequency pulse (49) to the second nuclear spin at a resonance frequency of the second nuclear spin;
wherein a phase of the fourth radiofrequency pulse (49) is different from a phase of the third radiofrequency pulse (37) and/or wherein a first separation time (τ_{S1}) between the first radiofrequency pulse (36) and the second radiofrequency pulse (48) is different from a second separation time (τ_{S2}) between the third radiofrequency pulse (37) and the fourth radiofrequency pulse (49);
and wherein the measurement (46) is preferably configured to distinguish a first signal originating from the nuclear spin and a second signal originating from the second nuclear spin according to the phases of the measured signals, the phases of the measured signals being encoded by the phase difference between the first and second radiofrequency pulses (36,48) and the phase difference between the third and fourth radiofrequency pulses (37,49), and/or wherein the measurement (46) is preferably configured to distinguish a first signal originating from the nuclear spin and a second signal originating from the second nuclear spin according to different delays of the respective signals from the time of the refocusing radiofrequency pulse (40), the different delays being associated with the first separation time (τ_{S1}) and the second separation time (τ_{S2}).

6. The method of any one of claims 3 to 5, wherein the gradient pulse area of the first, second and third magnetic field gradient pulses (38,39,44) are equal or deviating by 10% or less, preferably 1% or less, or which comprises applying a fourth magnetic field gradient pulse (51) after the refocusing radiofrequency pulse (40) to select the excitation in the second nuclear spin, wherein the gradient pulse area of the fourth magnetic field gradient pulse (51) preferably corresponds to the difference of the gradient pulse area of the third magnetic field gradient pulse (39) and the first magnetic field gradient pulse (38) or a gradient pulse area deviating from said difference by 10% or less, preferably 1% or less, wherein, after applying the fourth magnetic field gradient pulse (51), an additional measurement (52) is preferably performed to measure the second signal.

7. The method of any one of claims 3 to 6, the measuring further comprising the steps of:
applying a fifth magnetic field gradient pulse (50) after the second magnetic field gradient pulse (44) for reversing the evolution of the nuclear spins of the solvent induced by the second magnetic field gradient pulse, the gradient pulse area of the fifth magnetic field gradient pulse (50) having the same magnitude as the gradient pulse area of the second magnetic field gradient pulse (44) or a magnitude deviating by 5% or less, preferably 1% or less; and
performing an additional measurement (52) after applying the fifth magnetic field gradient pulse (50) for retrieving a chemical exchange saturation transfer signal of the nuclear spins saturated by the at least one preparation sequence (34).

8. The method of claim 1 or 2, wherein the refocusing radiofrequency pulse (40) is a π-pulse or deviating from a π-pulse by π/9 or less, preferably π/18 or less, wherein a number of preparation sequences (34) is preferably used to encode the excitation, and an equal number of second gradient pulses (44) is used to select the excitation in the nuclear spin, in particular wherein the number is greater than 1, preferably greater than 10, most preferably greater than 20.

9. A system (10) for detecting a solute in a solvent using nuclear magnetic resonance, wherein the solute performs chemical exchange of a proton with the solvent, comprising:
an excitation module (12), the excitation module (12) comprising
- a radiofrequency emitter (14) configured to generate a radiofrequency pulse (36,37,40,48,49); and
- a gradient pulsing device (16) configured to generate a magnetic field gradient (38,39,44,50,51) ;
wherein the excitation module (12) is configured to encode an excitation in a nuclear spin of the solute by applying at least one preparation sequence (34), the preparation sequence (34) comprising:
- a first radiofrequency pulse (36) at a resonance frequency of the solute; and
- a first magnetic field gradient pulse (38) after the first radiofrequency pulse (36); and
wherein the excitation module (12) is further configured to apply
- a refocusing radiofrequency pulse (40) at a resonance frequency of the solvent after the at least one preparation sequence (34); and
- a second magnetic field gradient pulse (44) after the refocusing radiofrequency pulse (40), wherein the second magnetic field gradient pulse (44) and the first magnetic field gradient pulse (38) have the same gradient pulse area or a gradient pulse area deviating by 10% or less, preferably 1% or less.

10. The system of claim 9, further comprising a means (24) configured to generate a longitudinal magnetic field, in particular a longitudinal magnetic field coil and/or a material with a magnetic remanence.

11. The system of claim 9 or 10, wherein the excitation module (12) is configured to apply a number of preparation sequences (34) to encode the excitation and to apply an equal number of second gradient pulses (44) after the refocusing radiofrequency pulse (40), in particular wherein the number is greater than 1, preferably greater than 10, most preferably greater than 20.

12. The system of claim 9 or 10, wherein the preparation sequence (34) further comprises a second radiofrequency pulse (48) at a resonance frequency of the solute, the second radiofrequency pulse (48) being applied after the first magnetic field gradient pulse (38) of the preparation sequence (34).

13. The system of claim 12, wherein the first and the second radiofrequency pulses (36,48) produce the same flip angle or a flip angle deviating by 30% or less, preferably 10% or less, most preferably 5% or less, wherein the first and the second radiofrequency pulses (36,48) are preferably π/2-pulses or deviating from a π/2-pulse by π/4 or less, preferably π/6 or less, most preferably π/9 or less and/or wherein the refocusing radiofrequency pulse (40) is preferably a π/2-pulse or deviates from a π/2-pulse by π/4 or less, in particular π/6 or less, preferably π/9 or less.

14. A computer program comprising instructions which, when executed by a computer controlling a NMR device for detecting a solute in a solvent using nuclear magnetic resonance, cause the NMR device to perform the steps of:
encoding an excitation in a nuclear spin of the solute comprising at least one preparation sequence (34), wherein said preparation sequence (34) comprises the steps of:
- applying a first radiofrequency pulse (36) to the nuclear spin at a resonance frequency of the solute (S10); and
- applying a first magnetic field gradient pulse (38) suitable for changing a phase of the nuclear spin (S12); and
measuring the excitation in the nuclear spin, said measuring including the steps of:
- applying a refocusing radiofrequency pulse (40) at a resonance frequency of the solvent for refocusing said nuclear spin transferred to the solvent by chemical exchange (S14);
- applying a second magnetic field gradient pulse (44) to thereby select the excitation in the nuclear spin (S16); and
- performing a measurement (46) of the excitation in the nuclear spin excited by the first radiofrequency pulse (36) at the resonance frequency of the solute and refocused with the refocusing radiofrequency pulse (40) at the resonance frequency of the solvent (S18), wherein the second magnetic field gradient pulse (44) and the first magnetic field gradient pulse (38) have the same gradient pulse area or a gradient pulse area deviating by 10% or less, preferably 1% or less.

## Patentansprüche

1. Verfahren zum Erkennen eines gelösten Stoffs in einem Lösungsmittel unter Verwendung von kernmagnetischer Resonanz, wobei der gelöste Stoff chemischen Austausch eines Protons mit dem Lösungsmittel durchführt, wobei das Verfahren die folgenden Schritte umfasst:
Kodieren einer Anregung in einem Kernspin des gelösten Stoffs, welches mindestens eine Vorbereitungssequenz (34) umfasst, wobei die Vorbereitungssequenz (34) die folgenden Schritte umfasst:
- Anwenden eines ersten Hochfrequenzpulses (36) auf den Kernspin bei einer Resonanzfrequenz des gelösten Stoffs (S10); und
- Anwenden eines ersten Magnetfeldgradientenpulses (38), der zum Ändern einer Phase des Kernspins (S12) geeignet ist; und
Messen der Anregung in dem Kernspin, wobei das Messen die folgenden Schritte umfasst:
- Anwenden eines refokussierenden Hochfrequenzpulses (40) bei einer Resonanzfrequenz des Lösungsmittels zum Refokussieren des durch chemischen Austausch (S14) auf das Lösungsmittel übertragenen Kernspins;
- Anwenden eines zweiten Magnetfeldgradientenpulses (44), um dadurch die Anregung in dem Kernspin (S16) auszuwählen; und
- Durchführen einer Messung (46) der Anregung in dem Kernspin, welcher durch den ersten Hochfrequenzpuls (36) bei der Resonanzfrequenz des gelösten Stoffs angeregt wurde und welcher durch den refokussierenden Hochfrequenzpuls (40) bei der Resonanzfrequenz des Lösungsmittels (S18) refokussiert wurde,
wobei der zweite Magnetfeldgradientenpuls (44) und der erste
Magnetfeldgradientenpuls (38) die gleiche Gradientenpulsfläche aufweisen oder Gradientenpulsflächen aufweisen, welche um 10% oder weniger, vorzugsweise 1% oder weniger, voneinander abweichen.

2. Verfahren nach Anspruch 1, wobei der erste Hochfrequenzpuls (36) ein π/2-Puls ist oder von einem π/2-Puls um π/4 oder weniger, insbesondere π/6 oder weniger, vorzugsweise π/9 oder weniger, abweicht.

3. Verfahren nach Anspruch 1 oder 2, wobei die Vorbereitungssequenz (34) ferner den Schritt umfasst:
Anwenden eines zweiten Hochfrequenzpulses (48) bei der Resonanzfrequenz des gelösten Stoffs nach dem Anwenden des ersten Magnetfeldgradientenpulses (38).

4. Verfahren nach Anspruch 3, wobei der erste und der zweite Hochfrequenzpuls (36, 48) den gleichen Flipwinkel erzeugen oder Flipwinkel erzeugen, welche um 30% oder weniger, vorzugsweise 10% oder weniger, am meisten bevorzugt 5% oder weniger, voneinander abweichen, wobei der erste und der zweite Hochfrequenzpuls (36, 48) vorzugsweise π/2-Pulse sind oder von einem π/2-Puls um π/4 oder weniger, vorzugsweise π/6 oder weniger, am meisten bevorzugt π/9 oder weniger, abweichen und/oder wobei der zweite Hochfrequenzpuls (40) vorzugsweise ein π/2-Puls ist oder von einem π/2-Puls um π/4 oder weniger, insbesondere π/6 oder weniger, vorzugsweise π/9 oder weniger, abweicht.

5. Verfahren nach Anspruch 3 oder 4, welches ferner das Erkennen einer Anregung in einem zweiten Kernspin eines zweiten gelösten Stoffs und/oder einer Anregung in einem zweiten Kernspin ermöglicht, welcher sich an einer anderen Austauschstelle des gelösten Stoffs befindet als die Austauschstelle des Kernspins, wobei die Vorbereitungssequenz ferner die folgenden Schritte umfasst:
- Anwenden eines dritten Hochfrequenzpulses (37) auf den zweiten Kernspin bei einer Resonanzfrequenz des zweiten Kernspins; und
- Anwenden eines dritten Magnetfeldgradientenpulses (39), der zum Ändern einer Phase des zweiten Kernspins geeignet ist;
- Anwenden eines vierten Hochfrequenzpulses (49) auf den zweiten Kernspin bei einer Resonanzfrequenz des zweiten Kernspins;
wobei sich eine Phase des vierten Hochfrequenzpulses (49) von einer Phase des dritten Hochfrequenzpulses (37) unterscheidet und/oder wobei sich ein erster zeitlicher Abstand (τS1) zwischen dem ersten Hochfrequenzpuls (36) und dem zweiten Hochfrequenzpuls (48) von einem zweiten zeitlichen Abstand (τS2) zwischen dem dritten Hochfrequenzpuls (37) und dem vierten Hochfrequenzpuls (49) unterscheidet;
und wobei die Messung (46) vorzugsweise eingerichtet ist, ein erstes Signal, das von der Kernspin stammt, und ein zweites Signal, das von der zweiten Kernspin stammt, gemäß den Phasen der gemessenen Signale zu unterscheiden, wobei die Phasen der gemessenen Signale durch die Phasendifferenz zwischen den ersten und zweiten Hochfrequenzpulsen (36, 48) und die Phasendifferenz zwischen den dritten und vierten Hochfrequenzpulsen (37,49) kodiert sind, und/oder wobei die Messung (46) vorzugsweise eingerichtet ist, ein erstes Signal, das von der Kernspin stammt, und ein zweites Signal, das von der zweiten Kernspin stammt, anhand unterschiedlicher Verzögerungen der jeweiligen Signale vom Zeitpunkt des refokussierenden Hochfrequenzpulses (40) zu unterscheiden, wobei die unterschiedlichen Verzögerungen mit dem ersten zeitlichen Abstand (τS1) und dem zweiten zeitlichen Abstand (τS2) zusammenhängen.

6. Verfahren nach einem der Ansprüche 3 bis 5, wobei die Gradientenpulsflächen der ersten, zweiten und dritten Magnetfeldgradientenpulse (38, 39, 44) gleich sind oder um 10% oder weniger, vorzugsweise 1% oder weniger, voneinander abweichen, oder welches das Anwenden eines vierten Magnetfeldgradientenpulses (51) nach dem refokussierenden Hochfrequenzpuls (40) umfasst, um die Anregung in dem zweiten Kernspin zu wählen, wobei der Gradientenpulsbereich des vierten Magnetfeldgradientenpulses (51) vorzugsweise der Differenz des Gradientenpulsbereichs des dritten Magnetfeldgradientenpulses (39) und des ersten Magnetfeldgradientenpulses (38) oder einem von der Differenz um 10% oder weniger, vorzugsweise 1% oder weniger, abweichenden Gradientenpulsbereich entspricht, wobei nach dem Anwenden des vierten Magnetfeldgradientenpulses (51) vorzugsweise eine weitere Messung (52) durchgeführt wird, um das zweite Signal zu messen.

7. Verfahren nach einem der Ansprüche 3 bis 6, wobei das Messen ferner die folgenden Schritte umfasst:
Anlegen eines fünften Magnetfeldgradientenpulses (50) nach dem zweiten Magnetfeldgradientenpuls (44) zum Umkehren der Entwicklung der Kernspins des Lösungsmittels, welche durch den zweiten Magnetfeldgradientenpuls induziert wird, wobei die Gradientenpulsfläche des fünften Magnetfeldgradientenpulses (50) die gleiche Größe aufweist wie die Gradientenpulsfläche des zweiten Magnetfeldgradientenpulses (44) oder eine Größe aufweist, welche um 5% oder weniger, vorzugsweise 1% oder weniger, von dieser abweicht; und Durchführen einer weiteren Messung (52) nach dem Anlegen des fünften Magnetfeldgradientenpulses (50) zum Wiederherstellen eines chemischen Austauschsättigungstransfersignals der Kernspins, welche durch die mindestens eine Vorbereitungssequenz (34) gesättigt wurden.

8. Verfahren nach Anspruch 1 oder 2, wobei der refokussierende Hochfrequenzpuls (40) ein π-Puls ist oder von einem π-Puls um π/9 oder weniger, vorzugsweise π/18 oder weniger, abweicht, wobei vorzugsweise eine Anzahl von Vorbereitungssequenzen (34) verwendet wird, um die Anregung zu kodieren, und eine gleiche Anzahl von zweiten Gradientenpulsen (44) verwendet wird, um die Anregung in der Kernspin auszuwählen, wobei insbesondere die Anzahl größer als 1, vorzugsweise größer als 10, am meisten bevorzugt größer als 20, ist.

9. System (10) zum Erkennen eines gelösten Stoffs in einem Lösungsmittel unter Verwendung von kernmagnetischer Resonanz, wobei der gelöste Stoff einen chemischen Austausch eines Protons mit dem Lösungsmittel durchführt, umfassend:
ein Anregungsmodul (12), wobei das Anregungsmodul (12) umfasst:
- einen Hochfrequenzemitter (14), der eingerichtet ist, einen Hochfrequenzpuls (36, 37, 40, 48, 49) zu erzeugen; und
- eine Gradientenpulsvorrichtung (16), die eingerichtet ist, einen Magnetfeldgradienten (38, 39, 44, 50, 51) zu erzeugen;
wobei das Anregungsmodul (12) eingerichtet ist, eine Anregung in einem Kernspin des gelösten Stoffs durch Anwenden mindestens einer Vorbereitungssequenz (34) zu kodieren, wobei die Vorbereitungssequenz (34) umfasst:
- einen ersten Hochfrequenzpuls (36) bei einer Resonanzfrequenz des gelösten Stoffs; und
- einen ersten Magnetfeldgradientenpuls (38) nach dem ersten Hochfrequenzpuls (36); und
wobei das Anregungsmodul (12) ferner eingerichtet ist,
- einen refokussierenden Hochfrequenzpuls (40) bei einer Resonanzfrequenz des Lösungsmittels nach der mindestens einen Vorbereitungssequenz (34) anzuwenden; und
- einen zweiten Magnetfeldgradientenpuls (44) nach dem refokussierenden Hochfrequenzpuls (40) anzuwenden, wobei der zweite Magnetfeldgradientenpuls (44) und der erste Magnetfeldgradientenpuls (38) die gleiche Gradientenpulsfläche aufweisen oder Gradientenpulsflächen aufweisen, welche um 10% oder weniger, vorzugsweise 1% oder weniger, voneinander abweichen.

10. System nach Anspruch 9, ferner umfassend ein Mittel (24), welches eingerichtet ist, ein longitudinales Magnetfeld zu erzeugen, insbesondere eine longitudinale Magnetfeldspule und/oder ein Material mit einer magnetischen Remanenz.

11. System nach Anspruch 9 oder 10, wobei das Anregungsmodul (12) eingerichtet ist, eine Anzahl von Vorbereitungssequenzen (34) anzuwenden, um die Anregung zu kodieren, und eine gleiche Anzahl von zweiten Gradientenpulsen (44) nach dem refokussierenden Hochfrequenzpuls (40) anzuwenden, wobei insbesondere die Anzahl größer als 1, vorzugsweise größer als 10, am meisten bevorzugt größer als 20, ist.

12. System nach Anspruch 9 oder 10, wobei die Vorbereitungssequenz (34) ferner einen zweiten Hochfrequenzpuls (48) bei einer Resonanzfrequenz des gelösten Stoffs umfasst, wobei der zweite Hochfrequenzpuls (48) nach dem ersten Magnetfeldgradientenpuls (38) der Vorbereitungssequenz (34) angewendet wird.

13. System nach Anspruch 12, wobei der erste und der zweite Hochfrequenzpuls (36, 48) den gleichen Flipwinkel oder Flipwinkel erzeugen, die um 30% oder weniger, vorzugsweise 10% oder weniger, am meisten bevorzugt 5% oder weniger, voneinander abweichen, wobei der erste und der zweite Hochfrequenzpuls (36, 48) vorzugsweise π/2-Pulse sind oder von einem π/2-Puls um π/4 oder weniger, vorzugsweise π/6 oder weniger, am meisten bevorzugt π/9 oder weniger, abweichen und/oder wobei der zweite Hochfrequenzpuls (40) vorzugsweise ein π/2-Puls ist oder von einem π/2-Puls um π/4 oder weniger, insbesondere π/6 oder weniger, vorzugsweise π/9 oder weniger, abweicht.

14. Computerprogramm, das Anweisungen umfasst, die, wenn sie von einem Computer ausgeführt werden, der eine NMR-Vorrichtung zum Detektieren eines gelösten Stoffs in einem Lösungsmittel unter Verwendung von kernmagnetischer Resonanz steuert, die NMR-Vorrichtung veranlassen, die folgenden Schritte durchzuführen:
Kodieren einer Anregung in einem Kernspin des gelösten Stoffs, der mindestens eine Vorbereitungssequenz (34) umfasst, wobei die Vorbereitungssequenz (34) die folgenden Schritte umfasst:
- Anwenden eines ersten Hochfrequenzpulses (36) auf den Kernspin bei einer Resonanzfrequenz des gelösten Stoffs (S10); und
- Anwenden eines ersten Magnetfeldgradientenpulses (38), der zum Ändern einer Phase des Kernspins (S12) geeignet ist; und
Messen der Anregung im Kernspin, wobei das Messen die folgenden Schritte umfasst:
- Anwenden eines refokussierenden Hochfrequenzpulses (40) bei einer Resonanzfrequenz des Lösungsmittels zum Refokussieren des durch chemischen Austausch (S14) auf das Lösungsmittel übertragenen Kernspins;
- Anwenden eines zweiten Magnetfeldgradientenpulses (44), um dadurch die Anregung im Kernspin (S16) auszuwählen; und
- Durchführen einer Messung (46) der Anregung in dem Kernspin, welcher durch den ersten Hochfrequenzpuls (36) bei der Resonanzfrequenz des gelösten Stoffs angeregt wurde und welcher durch den refokussierenden Hochfrequenzpuls (40) bei der Resonanzfrequenz des Lösungsmittels (S18) refokussiert wurde, wobei der zweite Magnetfeldgradientenpuls (44) und der erste Magnetfeldgradientenpuls (38) die gleiche Gradientenpulsfläche oder eine um 10% oder weniger, vorzugsweise 1% oder weniger, abweichende Gradientenpulsfläche aufweisen.

## Revendications

1. Procédé de détection d'un soluté dans un solvant par résonance magnétique nucléaire, dans lequel le soluté effectue un échange chimique d'un proton avec le solvant, ledit procédé comprenant les étapes de :
codage d'une excitation dans un spin nucléaire du soluté comprenant au moins une séquence de préparation (34), où ladite séquence de préparation (34) comprend les étapes de :
- application d'une première impulsion de radiofréquence (36) au spin nucléaire à une fréquence de résonance du soluté (S10) ; et
- application d'une première impulsion de gradient de champ magnétique (38) adaptée pour modifier une phase du spin nucléaire (S12) ; et
mesure de l'excitation dans le spin nucléaire, ladite mesure comprenant les étapes de :
- application d'une impulsion de radiofréquence de refocalisation (40) à une fréquence de résonance du solvant pour refocaliser ledit spin nucléaire transféré au solvant par échange chimique (S14) ;
- application d'une deuxième impulsion de gradient de champ magnétique (44) de façon à sélectionner l'excitation dans le spin nucléaire (S16) ; et
- conduite d'une mesure (46) de l'excitation dans le spin nucléaire excité par la première impulsion de radiofréquence (36) à la fréquence de résonance du soluté et refocalisé avec l'impulsion de radiofréquence de refocalisation (40) à la fréquence de résonance du solvant (S18),
dans lequel la deuxième impulsion de gradient de champ magnétique (44) et la première impulsion de gradient de champ magnétique (38) ont la même aire d'impulsion de gradient ou des aires d'impulsion de gradient s'écartant de 10 % ou moins, de préférence 1 % ou moins.

2. Procédé selon la revendication 1, dans lequel la première impulsion de radiofréquence (36) est une impulsion π/2 ou s'écartant d'une impulsion π/2 de π/4 ou moins, en particulier π/6 ou moins, de préférence π/9 ou moins.

3. Procédé selon la revendication 1 ou 2, dans lequel la séquence de préparation (34) comprend en outre l'étape de :
application d'une deuxième impulsion de radiofréquence (48) à la fréquence de résonance du soluté après l'application de la première impulsion de gradient de champ magnétique (38).

4. Procédé selon la revendication 3, dans lequel les première et deuxième impulsions de radiofréquence (36, 48) produisent le même angle de bascule ou des angles de bascule s'écartant de 30 % ou moins, de préférence 10 % ou moins, de manière préférée entre toutes 5 % ou moins, dans lequel les première et deuxième impulsions de radiofréquence (36,48) sont de préférence des impulsions π/2 ou s'écartant d'une impulsion π/2 de π/4 ou moins, de préférence π/6 ou moins, de manière préférée entre toutes π/9 ou moins et/ou dans lequel l'impulsion de radiofréquence de refocalisation (40) est de préférence une impulsion π/2 ou s'écartant d'une impulsion π/2 de π/4 ou moins, en particulier π/6 ou moins, de préférence π/9 ou moins.

5. Procédé selon la revendication 3 ou 4, qui permet en outre la détection d'une excitation dans un deuxième spin nucléaire d'un deuxième soluté et/ou d'une excitation dans un deuxième spin nucléaire situé à un site d'échange différent du soluté en tant que site d'échange du spin nucléaire, dans lequel la séquence de préparation comprend en outre les étapes de :
- application d'une troisième impulsion de radiofréquence (37) au deuxième spin nucléaire à une fréquence de résonance du deuxième spin nucléaire ; et
- application d'une troisième impulsion de gradient de champ magnétique (39) adaptée pour modifier une phase du deuxième spin nucléaire ;
- application d'une quatrième impulsion de radiofréquence (49) au deuxième spin nucléaire à une fréquence de résonance du deuxième spin nucléaire ;
dans lequel une phase de la quatrième impulsion de radiofréquence (49) est différente d'une phase de la troisième impulsion de radiofréquence (37) et/ou dans lequel un premier temps de séparation (τ_{S1}) entre la première impulsion de radiofréquence (36) et la deuxième impulsion de radiofréquence (48) est différent d'un deuxième temps de séparation (τ_{S2}) entre la troisième impulsion de radiofréquence (37) et la quatrième impulsion de radiofréquence (49) ;
et dans lequel la mesure (46) est de préférence configurée pour distinguer un premier signal provenant du spin nucléaire et un deuxième signal provenant du deuxième spin nucléaire en fonction des phases des signaux mesurés, les phases des signaux mesurés étant codées par le déphasage entre les première et deuxième impulsions de radiofréquence (36, 48) et le déphasage entre les troisième et quatrième impulsions de radiofréquence (37, 49), et/ou dans lequel la mesure (46) est de préférence configurée pour distinguer un premier signal provenant du spin nucléaire et un deuxième signal provenant du deuxième spin nucléaire en fonction de différents retards des signaux respectifs par rapport au temps de l'impulsion de radiofréquence de refocalisation (40), les différents retards étant associés au premier temps de séparation (τ_{S1}) et au deuxième temps de séparation (τ_{S2}).

6. Procédé selon l'une quelconque des revendications 3 à 5, dans lequel les aires d'impulsion de gradient des première, deuxième et troisième impulsions de gradient de champ magnétique (38,39,44) sont égales ou s'écartent de 10 % ou moins, de préférence 1 % ou moins, ou qui comprend l'application d'une quatrième impulsion de gradient de champ magnétique (51) après l'impulsion de radiofréquence de refocalisation (40) pour sélectionner l'excitation dans le deuxième spin nucléaire, dans lequel l'aire d'impulsion de gradient de la quatrième impulsion de gradient de champ magnétique (51) correspond de préférence à la différence entre l'aire d'impulsion de gradient de la troisième impulsion de gradient de champ magnétique (39) et la première impulsion de gradient de champ magnétique (38) ou une aire d'impulsion de gradient s'écartant de ladite différence de 10 % ou moins, de préférence 1 % ou moins, dans lequel l'application de la quatrième impulsion de gradient de champ magnétique (51), une mesure supplémentaire (52) est de préférence effectuée pour mesurer le deuxième signal.

7. Procédé selon l'une quelconque des revendications 3 à 6, la mesure comprenant en outre les étapes de :
application d'une cinquième impulsion de gradient de champ magnétique (50) après la deuxième impulsion de gradient de champ magnétique (44) pour inverser l'évolution des spins nucléaires du solvant induite par la deuxième impulsion de gradient de champ magnétique, l'aire d'impulsion de gradient de la cinquième impulsion de gradient de champ magnétique (50) ayant la même amplitude que l'aire d'impulsion de gradient de la deuxième impulsion de gradient de champ magnétique (44) ou une amplitude s'écartant de 5 % ou moins, de préférence 1 % ou moins ; et
conduite d'une mesure supplémentaire (52) après l'application de la cinquième impulsion de gradient de champ magnétique (50) pour extraire un signal de transfert de saturation d'échange chimique des spins nucléaires saturés par l'au moins une séquence de préparation (34).

8. Procédé selon la revendication 1 ou 2, dans lequel l'impulsion de radiofréquence de refocalisation (40) est une impulsion π ou s'écarte d'une impulsion π de π/9 ou moins, de préférence π/18 ou moins, dans lequel un nombre de séquences de préparation (34) est de préférence utilisé pour coder l'excitation, et un nombre égal de deuxièmes impulsions de gradient (44) est utilisé pour sélectionner l'excitation dans le spin nucléaire, en particulier dans lequel le nombre est supérieur à 1, de préférence supérieur à 10, de manière préférée entre toutes supérieur à 20.

9. Système (10) de détection d'un soluté dans un solvant par résonance magnétique nucléaire, dans lequel le soluté effectue un échange chimique d'un proton avec le solvant, comprenant :
un module d'excitation (12), le module d'excitation (12) comprenant
- un émetteur de radiofréquence (14) configuré pour générer une impulsion de radiofréquence (36,37,40,48,49) ; et
- un dispositif d'impulsion de gradient (16) configuré pour générer un gradient de champ magnétique (38,39, 44, 50, 51) ;
dans lequel le module d'excitation (12) est configuré pour coder une excitation dans un spin nucléaire du soluté par application d'au moins une séquence de préparation (34), la séquence de préparation (34) comprenant :
- une première impulsion de radiofréquence (36) à une fréquence de résonance du soluté ; et
- une première impulsion de gradient de champ magnétique (38) après la première impulsion de radiofréquence (36) ; et
dans lequel le module d'excitation (12) est en outre configuré pour appliquer
- une impulsion de radiofréquence de refocalisation (40) à une fréquence de résonance du solvant après l'au moins une séquence de préparation (34) ; et
- une deuxième impulsion de gradient de champ magnétique (44) après l'impulsion de radiofréquence de refocalisation (40), dans lequel la deuxième impulsion de gradient de champ magnétique (44) et la première impulsion de gradient de champ magnétique (38) ont la même aire d'impulsion de gradient ou une aire d'impulsion de gradient s'écartant de 10 % ou moins, de préférence 1 % ou moins.

10. Système selon la revendication 9, comprenant en outre un moyen (24) configuré pour générer un champ magnétique longitudinal, en particulier une bobine à champ magnétique longitudinal et/ou un matériau ayant une rémanence magnétique.

11. Système selon la revendication 9 ou 10, dans lequel le module d'excitation (12) est configuré pour appliquer un nombre de séquences de préparation (34) pour coder l'excitation et pour appliquer un nombre égal de deuxièmes impulsions de gradient (44) après l'impulsion de radiofréquence de refocalisation (40), en particulier dans lequel le nombre est supérieur à 1, de préférence supérieur à 10, de manière préférée entre toutes supérieur à 20.

12. Système selon la revendication 9 ou 10, dans lequel la séquence de préparation (34) comprend en outre une deuxième impulsion de radiofréquence (48) à une fréquence de résonance du soluté, la deuxième impulsion de radiofréquence (48) étant appliquée après la première impulsion de gradient de champ magnétique (38) de la séquence de préparation (34).

13. Système selon la revendication 12, dans lequel les première et deuxième impulsions de radiofréquence (36, 48) produisent le même angle de bascule ou un angle de bascule s'écartant de 30 % ou moins, de préférence 10 % ou moins, de manière préférée entre toutes 5 % ou moins, dans lequel les première et deuxième impulsions de radiofréquence (36,48) sont de préférence des impulsions π/2 ou s'écartant d'une impulsion π/2 de π/4 ou moins, de préférence π/6 ou moins, de manière préférée entre toutes π/9 ou moins et/ou dans lequel l'impulsion de radiofréquence de refocalisation (40) est de préférence une impulsion π/2 ou s'écartant d'une impulsion π/2 de π/4 ou moins, en particulier π/6 ou moins, de préférence π/9 ou moins.

14. Programme informatique comprenant des instructions qui, lorsqu'elles sont exécutées par un ordinateur commandant un dispositif de RMN pour la détection d'un soluté dans un solvant par résonance magnétique nucléaire, amènent le dispositif RMN à effectuer les étapes de :
codage d'une excitation dans un spin nucléaire du soluté comprenant au moins une séquence de préparation (34), où ladite séquence de préparation (34) comprend les étapes de :
- application d'une première impulsion de radiofréquence (36) au spin nucléaire à une fréquence de résonance du soluté (S10) ; et
- application d'une première impulsion de gradient de champ magnétique (38) adaptée pour modifier une phase du spin nucléaire (S12) ; et
mesure de l'excitation dans le spin nucléaire, ladite mesure comprenant les étapes de :
- application d'une impulsion de radiofréquence de refocalisation (40) à une fréquence de résonance du solvant pour refocaliser ledit spin nucléaire transféré au solvant par échange chimique (S14) ;
- application d'une deuxième impulsion de gradient de champ magnétique (44) de façon à sélectionner l'excitation dans le spin nucléaire (S16) ; et
- conduite d'une mesure (46) de l'excitation dans le spin nucléaire excité par la première impulsion de radiofréquence (36) à la fréquence de résonance du soluté et refocalisé avec l'impulsion de radiofréquence de refocalisation (40) à la fréquence de résonance du solvant (S18), dans lequel la deuxième impulsion de gradient de champ magnétique (44) et la première impulsion de gradient de champ magnétique (38) ont la même aire d'impulsion de gradient ou une aire d'impulsion de gradient s'écartant de 10 % ou moins, de préférence 1 % ou moins.
